# EUROPEAN PATENT APPLICATION

(11) **EP 4 835 570 A1**
(43) Date of publication of application: **04.11.2026**
(21) Application number: 24912544.4
(22) Date of filing: 17.12.2024
(51) Int. Cl.: G03F 7/004, G03F 7/20, G03F 7/039

(54) **RESIST MATERIAL, PATTERN FORMATION METHOD, AND PATTERNED STRUCTURE**

(30) Priority: 27.12.2023 JP 2023221800
(71) Applicant: Tokyo Ohka Kogyo Co., Ltd., Kawasaki-shi, Kanagawa 211-0012 (JP)
(72) Inventor: NISHIZAWA, Akito, Kawasaki-shi, Kanagawa 211-0012 (JP); INARI, Takatoshi, Kawasaki-shi, Kanagawa 211-0012 (JP); KIMURA, Kenta, Kawasaki-shi, Kanagawa 211-0012 (JP); NAGATA, Masaya, Kawasaki-shi, Kanagawa 211-0012 (JP)
(74) Representative: Plasseraud IP
(86) International application number: PCT/JP2024/044674
(87) International publication number: WO 2025/142655

(57) **Abstract**

An object of the present invention is to provide a novel resist material containing (A) a heter opolyacid salt having a modified lacunary site represented by the general formula (I) or a mixture thereo f, wherein a sulfonium cation, a sulfonium dication, or an iodonium cation, each having one or more po lar groups each having an acid-dissociable group, is introduced into a cation moiety of the heteropolyaci d salt having a modified lacunary site or the mixture thereof, a pattern formation method, and a patterne d structure.

(A^{m+})ₐ(Bⁿ⁺)_{b}(C^{(am+bn)-}) (I)

## Description

### Technical Field

The present invention relates to a resist material, a pattern formation method, and a patterned structure.

### Background Art

The polyacid is an anionic metal oxide cluster represented by the general formula [MₓO_{y}]ⁿ⁻ (wherein x, y, and n all denote natural numbers). The metal atom M constituting the polyacid is referred to as a polyatom and is, for example, Mo (hexavalent or pentavalent), W (hexavalent or pentavalent), V (pentavalent), Nb (pentavalent), Ta (pentavalent), or the like. The polyacid can be broadly divided into an isopolyacid composed of the polyatom M and an oxoacid, and a heteropolyacid ([X_{w}MₓO_{y}]ⁿ⁻ (wherein w, x, y, and n all denote natural numbers)) containing a different type of heteroatom X (for example, P⁵⁺, Si⁴⁺, Ge⁴⁺, B³⁺, or the like as a heteroatom X) in addition to the polyatom M and oxygen.

The physicochemical properties of a polyacid, such as redox ability, actinic radiation reactivity, and acid properties, can be changed depending on the combination and structure of the constituent elements, the type of counter cation, or the like.

Furthermore, it is known that there are a plurality of lacunary species having a defect in part of the basic skeleton in the polyacid. A terminal oxygen atom at a lacunary site having a defect in part of the basic skeleton of the polyacid has a certain degree of negative charge density on the oxygen atom, has high reactivity, and has nucleophilicity. Thus, various functional polyacid complexes or organic/inorganic hybrid structures can be formed by reacting the terminal oxygen atom with an electrophilic atom or molecule.

Patent Literature 1 discloses, as a polyoxometalate compound having a metal-substituted polyoxometalate, a polyoxometalate compound that has a polyoxometalate having a lacunary site, a substituting metal atom (divalent platinum or palladium) introduced into the lacunary site, and an organic ligand.

### Citation List

### Patent Literature

PTL 1: U.S. Patent No. 11420871

### Summary of Invention

### Technical Problem

The present invention aims to provide a novel resist material, a pattern formation method, and a patterned structure.

### Solution to Problem

As a result of extensive studies to solve the above problems, the present inventors have completed the present invention by finding that the use of a sulfonium cation, a sulfonium dication, or an iodonium cation, each having one or more polar groups each having an acid-dissociable group, as a counter cation of a heteropolyacid anion having a modified lacunary site can provide a novel resist material that can generate an acid upon exposure to DUV, XUV, EUV, an electron beam, or the like and change the solubility in a developer by the action of the acid, a pattern formation method, and a patterned structure.

That is, the present invention relates to the following inventions.
<1> A resist material comprising (A) a heteropolyacid salt having a modified lacunary site rep resented by the general formula (I) or a mixture thereof.

   (A^{m+})ₐ(Bⁿ⁺)_{b}(C^{(am+bn)-}) (I)

   [In the formula (I),
   A^{m+} each independently denotes H⁺, a metal ion, an ammonium cation, an ammonium dication , a phosphonium cation, or a phosphonium dication;
   Bⁿ⁺ each independently denotes a sulfonium cation, a sulfonium dication, or an iodonium catio n, each having one or more polar groups each having an acid-dissociable group;
   C^{(am+bn)-} denotes a heteropolyacid anion having a lacunary site in which the lacunary site is m odified; and
   m denotes an integer in the range of 1 to 5, n denotes an integer of 1 or 2, a denotes a real number, and b denotes a real number greater than 0]
<2> The resist material according to <1>, wherein the sulfonium cation, sulfonium dication, or iodonium cation having one or more polar groups each having an acid-dissociable group is an organic s ulfonium cation, an organic sulfonium dication, or an organic iodonium cation having one or more polar groups each having an acid-dissociable group.
<3> The resist material according to <1>, wherein the acid-dissociable group is a tertiary-carb on-type acid-dissociable group, an allyl- or benzyl-type acid-dissociable group, an acetal-type acid-dissocia ble group, or an aminocarbonyl-type acid-dissociable group.
<4> The resist material according to <1>, wherein the heteropolyacid anion has a polyatom of Mo, W, V, Nb, or Ta and a heteroatom of P, Si, B, S, or Ge.
<5> The resist material according to <1>, wherein the heteropolyacid anion having the lacunar y site is a lacunary Keggin-type heteropolyacid anion or a lacunary Dawson-type heteropolyacid anion.
<6> The resist material according to <1>, wherein the modification is performed by bonding a group having one or more heteroatoms of P, Si, Ge, or Sn, to which one or more organic groups are bonded, to the heteropolyacid anion having the lacunary site via a part or all of the heteroatoms.
<7> The resist material according to <1>, further comprising (B) an acid diffusion control age nt.
<8> The resist material according to <7>, wherein the (B) acid diffusion control agent is (B1) a photodegradable base.
<9> The resist material according to <1>, further comprising an organic solvent.
<10> The resist material according to any one of <1> to <9>, which is a resist material for an electron beam or EUV.
<11> A pattern formation method including:
   a step of forming a resist film using the resist material according to any one of <1> to <9>;
   a step of exposing the resist film; and
   a step of developing the exposed resist film using a developer.
<12> The pattern formation method according to <11>, wherein the step of exposing the resist film includes a step of exposing the resist film to an electron beam with a dose of 2 mC/cm² or less or extreme ultraviolet of 200 mJ/cm² or less.
<13> A patterned structure formed by patterning the resist material according to any one of < 1> to <9>.
<14> The resist material according to <5>, wherein the lacunary Keggin-type heteropolyacid anion is represented by the general formula (II-1), (II-2), or (II-3):

   [XM₁₁O₃₉]^{c11-} (II-1)

   [XM₁₀O₃₆]^{c12-} (II-2)

   [XM₉O₃₄]^{c13-} (II-3)

   (wherein
   X denotes a heteroatom of P, Si, B, S, or Ge,
   M denotes a polyatom of Mo, W, V, Nb, or Ta, and
   c11- to c13- denote the number of negative charges, and c11 to c13 denote natural numbers.)
<15> The resist material according to <5>, wherein the lacunary Dawson-type heteropolyacid anion is represented by the general formula (III-1), (III-2), or (III-3):

   [X₂M₁₇O₆₁]^{c21-} (III-1)

   [X₂M₁₆O₅₈]^{c22-} (III-2)

   [X₂M₁₅O₅₆]^{c23-} (111-3)

   (wherein
   X denotes a heteroatom of P, Si, B, S, or Ge,
   M denotes a polyatom of Mo, W, V, Nb, or Ta, and
   c21- to c23- denote the number of negative charges, and c21 to c23 denote natural numbers.)
<16> The resist material according to <1>, wherein the heteropolyacid anion having the modified lacunary site is a heteropolyacid anion having a modified lacunary site represented by any one of the general formulae (VI-1) to (VI-12):

   [XM₁₁O₃₉(R^{1A}X')₂O]^{c31-} (VI-1)

   [XM₁₁O₃₉(R^{1B1}R^{1B2}X')₂]^{c31-} (VI-2)

   [XM₁₁O₃₉(R^{1D}P=O)₂]^{c31-} (VI-3)

   [XM₁₁O₃₉(R^{1E}X")]^{c31-} (VI-4)

   [XM₁₀O₃₆(R^{1A}X')₂O]^{c32-} (VI-5)

   [XM₁₀O₃₆(R^{1B1}R^{1B2}X')₂]^{c32-} (VI-6)

   [XM₁₀O₃₆(R^{1C}X'O)₄]^{c32-} (VI-7)

   [XM₁₀O₃₆(R^{1D}P=O)₂]^{c32-} (VI-8)

   [X₂M₁₇O₆₁(R^{1A}X')₂O]^{c33-} (VI-9)

   [X₂M₁₇O₆₁(R^{1B1}R^{1B2}X')₂]^{c33-} (VI-10)

   [X₂M₁₇O₆₁(R^{1D}P=O)₂]^{c33-} (VI-11)

   [X₂M₁₇O₆₁(R^{1E}X")]^{c33-} (VI-12)

   (wherein
   X denotes a heteroatom of P, Si, B, S, or Ge,
   M denotes a polyatom of Mo, W, V, Nb, or Ta, and
   X' denotes a heteroatom of Si or Ge;
   X" denotes a heteroatom of Si, Ge, or Sn;
   R^{1A} to R^{1E} each independently denote a hydro group, an optionally substituted C₁₋₁₈ hydrocarbyl group, an optionally substituted 3- to 18-membered non-aromatic heterocyclic group, or an optionally substituted 5- to 18-membered aromatic heterocyclic group,
      a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time),
   a hydrogen atom in R^{1A} to R^{1E} may be substituted with, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and
   c31, c32, and c33 denote natural numbers)

### Advantageous Effects of Invention

The present invention can provide a novel resist material, a pattern formation method, and a p atterned structure. A resist material according to the present invention contains a heteropolyacid salt hav ing a modified lacunary site or a mixture thereof, and a sulfonium cation, a sulfonium dication, or an io donium cation, each having one or more polar groups each having an acid-dissociable group, is introduce d into a cation moiety of the heteropolyacid salt having a modified lacunary site or the mixture thereof. Thus, exposing a resist material according to the present invention to DUV, XUV, EUV, an electron be am, or the like can generate an acid, change the solubility of the resist material in a developer by the a ction of the acid, and form a pattern with high resolution.

### Description of Embodiments

Preferred embodiments of the present invention will be described in detail below. However, the present invention is not limited to the following embodiments.

In the present description, the term "(meth)acryloyl group" is used to mean both an acryloyl group and a methacryloyl group.

The term "halogen atom", as used herein, refers to a fluorine atom, a chlorine atom, a bromine atom, or an iodine atom.

In the present description, for example, the term "C₁₋₆" or the like means the number of carbon atoms of a group serving as a mother nucleus.

The term "C₁₋₁₈ hydrocarbylene group", as used herein, refers to a divalent hydrocarbon group formed by removing two hydrogen atoms from a hydrocarbon with 1 to 18 carbon atoms. The hydrocarbylene group may be linear, branched, or partially or fully cyclic. Examples of the hydrocarbylene group include an alkylene group and an arylene group.

A divalent carbon atom at any position of the "C₁₋₁₈ hydrocarbylene group" may be replaced by -O-, - S-, -C(=O)-, -COO-, -OCO-, -CONH-, -NHCO-, -NH(C=O)O-, -S-, -SO-, or -SO₂- (provided that adjacent divalent carbon atoms are not replaced at the same time).

The "C₁₋₁₈ hydrocarbylene group" is, for example, but not limited to, a "C₁₋₁₈ alkylene group", such as a methylene group, an ethylene group, a n-propylene group, an i-propylene group, a cyclopentadiyl group, a cyclohexanediyl group, an oxyethane-1,1-diyl group, an oxyethane-1,2-diyl group, an oxypropane-1,3-diyl group, an oxypropane-1,2-diyl group, a 2-methylpropane-1,3-diyl group, or an oxyethyleneoxyethane-1,1-diyl group; a "C₆₋₁₈ arylene group", such as a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group; or the like.

The term "C₁₋₁₈ alkyl group", as used herein, refers to a linear or branched alkyl group with 1 to 18 carbon atoms.

Furthermore, a divalent carbon atom at any position excluding the terminals contained in the "C₁₋₁₈ alkyl group" may be replaced by -O-, -C(=O)-, -C(=O)O-, -OCO-, -CONH-, -NHCO-, -NH(C=O)O-, -S-, or - SO₂-. However, adjacent divalent carbon atoms are not replaced at the same time.

The "C₁₋₁₈ alkyl group" is, for example, but not limited to, a methyl group, an ethyl group, a n-propyl group, an i-propyl group, a n-butyl group, an i-butyl group, a sec-butyl group, a t-butyl group, a n-pentyl group, an i-pentyl group, a sec-pentyl group, a t-pentyl group, a neopentyl group, a 1-methylbutyl group, a 2-methylbutyl group, a 1,1-dimethylpropyl group, a 1,2-dimethylpropyl group, a n-hexyl group, an i-hexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1,3-dimethylbutyl group, a 2,3-dimethylbutyl group, a 3,3-dimethylbutyl group, a 1-ethylbutyl group, a 2-ethylbutyl group, a 1,1,2-trimethylpropyl group, a 1,2,2-trimethylpropyl group, a 1-ethyl-1-methylpropyl group, a 1-ethyl-2-methylpropyl group, a n-heptyl group, a n-octyl group, a n-nonyl group, a n-decyl group, a n-undecyl group, a n-dodecyl group, or the like.

The "C₁₋₁₈ alkyl group" in which a divalent carbon atom at any position excluding the terminals thereof is replaced by -O-, -C(=O)-, -C(=O)O-, -OCO-, -CONH-, -NHCO-, -NH(C=O)O-, -S-, or -SO₂- is, for example, but not limited to, a 2-methoxyethoxymethyl group, an ethoxycarbonylmethyl group, or the like.

The term "C₁₋₁₈ haloalkyl group", as used herein, refers to a group in which one or more hydrogen atoms of the "C₁₋₁₈ alkyl group" are substituted by a halogen atom.

The "C₁₋₁₈ haloalkyl group" is, for example, but not limited to, a dichloromethyl group, a trifluoromethyl group, a 2,2-difluoroethyl group, a 2,2,2-trifluoroethyl group, a pentafluoroethyl group, a 3,3,3-trifluoropropyl group, or the like.

The term "C₂₋₁₈ alkenyl group", as used herein, refers to an alkenyl group with 2 or more carbon atoms having one or more double bonds in the "C₁₋₁₈ alkyl group" and includes an alkadienyl group, an alkatrienyl group, and the like.

The "C₂₋₁₈ alkenyl group" is, for example, but not limited to, a vinyl group (ethenyl group), an allyl group (2-propenyl group), a 1-propenyl group, an isopropenyl group (1-methylvinyl group), a 1-butenyl group, a 2-butenyl group, a 3-butenyl group, a pentenyl group, a hexenyl group, a heptenyl group, an octenyl group, a nonenyl group, a decenyl group, an undecenyl group, a dodecenyl group, or the like.

The term "C₂₋₁₈ alkynyl group", as used herein, refers to an alkynyl group with 2 or more carbon atoms having one or more triple bonds in the "C₁₋₁₈ alkyl group".

The "C₂₋₁₈ alkynyl group" is, for example, but not limited to, an ethynyl group, a 1-propynyl group, a 2-propynyl group, a pentynyl group, a hexynyl group, a heptynyl group, an octynyl group, a nonynyl group, a decynyl group, an undecynyl group, a dodecynyl group, or the like.

The term "C₃₋₁₈ alicyclic group", as used herein, refers to a hydrocarbon group with 3 to 18 carbon atoms and with a monocyclic or polycyclic structure in whole or in part. The alicyclic group includes a cycloalkyl group, a cycloalkenyl group, a cycloalkynyl group, a monocycloalkyl group, a polycycloalkyl group, and the like.

A divalent carbon atom at any position excluding the terminals contained in the "C₃₋₁₈ alicyclic group" may be replaced by -O-, -C(=O)-, -C(=O)O-, -OCO-, -CONH-, -NHCO-, -NH(C=O)O-, -S-, or -SO₂- (provided that adjacent divalent carbon atoms are not replaced at the same time).

The "C₃₋₁₉ cycloalkyl group" is, for example, but not limited to, a cyclopropyl group, a cyclobutyl group, a cyclopentyl group, a 1-i-propylcyclopentane-1-yl group, a cyclohexyl group, a t-butylcyclohexyl group, a tricyclodecanyl group, a cycloheptyl group, a cyclooctyl group, a cyclodecyl group, a 2-methyladamantane-2-yl group, a 2-i-propyladamantane-2-yl group, a bornyl group, a norbornyl group, a fenchyl group, a pinanyl group, an adamantyl group, a tricyclodecyl group, a tetracyclododecyl group, a cyclopropylmethyl group, a cyclobutylmethyl group, a cyclopentylmethyl group, a cyclohexylmethyl group, a bornylmethyl group, a norbornylmethyl group, an adamantylmethyl group, a 1-methylcyclopentyloxycarbonylmethyl group, a cyclopentenyl group, a cyclohexenyl group, a cycloheptenyl group, or the like.

The term "3- to 18-membered non-aromatic heterocyclic group", as used herein, refers to a 3- to 18-membered non-aromatic heterocyclic group containing one or more heteroatoms selected from the group consisting of a nitrogen atom, an oxygen atom, and a sulfur atom, may be monocyclic, polycyclic, or condensed, and may be saturated or partially unsaturated.

The "3- to 18-membered non-aromatic heterocyclic group" is, for example, but not limited to, an aziridinyl group, an azetidyl group, a pyrrolidinyl group, a pyrrolyl group, a piperidinyl group, a piperazinyl group, a morpholinyl group, a thiomorpholinyl group, a tetrahydrofuryl group, a tetrahydropyranyl group, an oxetanyl group, a tetrahydrofuryl group, a tetrahydropyranyl group, an imidazolinyl group, an oxazolinyl group, a 2,5-diazabicyclo[2.2.1]heptyl group, a 2,5-diazabicyclo[2.2.2]octyl group, a 3,8-diazabicyclo[3.2.1]octyl group, a 1,4-diazabicyclo[4.3.0]nonyl group, a 1-azaadamantyl group, a 2-azaadamantyl group, or the like.

The term "C₂₋₁₈ aryl group", as used herein, refers to an aromatic hydrocarbon ring group with 6 to 18 carbon atoms or an aromatic heterocyclic group with 2 to 10 carbon atoms; in the case of an aromatic heterocyclic group, 2 to 10 carbon atoms and one or more heteroatoms selected from the group consisting of a nitrogen atom, an oxygen atom, and a sulfur atom form a ring, and the ring may be monocyclic, polycyclic, or a fused ring.

The "C₂₋₁₈ aryl group" is, for example, but not limited to, a phenyl group, a 1-naphthyl group, a 2-naphthyl group, an azulenyl group, a pentalenyl group, a heptalenyl group, an indacenyl group, an acenaphthyl group, a phenanthrenyl group, an anthracenyl group, or the like.

The term "C₇₋₁₈ aralkyl group", as used herein, refers to a group in which a substitutable portion of a "C₁₋₁₂ alkyl group" is substituted by the "C₂₋₁₂ aryl group".

The "C₇₋₁₈ aralkyl group" is, for example, but not limited to, a benzyl group, a phenethyl group, a 3-phenylpropyl group, a 4-phenylbutyl group, a 1-naphthylmethyl group, or a 2-naphthylmethyl group, or the like.

The term "C₁₋₁₈ hydrocarbyl group", as used herein, refers to a monovalent group formed by removing one hydrogen atom from a hydrocarbon with 1 to 18 carbon atoms. Examples of the hydrocarbyl group include an alkyl group, an alkenyl group, an alkynyl group, an alicyclic group, an aryl group, an aralkyl group, and the like.

A divalent carbon atom at any position excluding the terminals contained in the "C₁₋₁₈ hydrocarbyl group" may be replaced by -O-, -C(=O)-, -C(=O)O-, -OCO-, -CONH-, -NHCO-, -NH(C=O)O-, -S-, or -SO₂-(provided that adjacent divalent carbon atoms are not replaced at the same time). The same applies to the "C₁₋₁₈ hydrocarbyl group" and the like used in the following description of the definition of the "C₁₋₁₈ hydrocarbyloxy group" and the like.

The "C₁₋₁₈ hydrocarbyl group" is, for example, but not limited to, a "C₁₋₁₈ alkyl group", a "C₂₋₁₈ alkenyl group", a "C₂₋₁₈ alkynyl group", a "C₃₋₁₈ alicyclic group", a "C₂₋₁₈ aryl group", a "C₇₋₁₈ aralkyl group", or the like.

The term "C₁₋₁₈ hydrocarbyloxy group", as used herein, refers to a group in which an oxygen atom (-O-) is bonded to the "C₁₋₁₈ hydrocarbyl group".

The "C₁₋₁₈ hydrocarbyloxy group" is, for example, but not limited to, a "C₁₋₁₈ alkoxy group", such as a methoxy group, an ethoxy group, a n-propoxy group, an i-propoxy group, a n-butoxy group, an i-butoxy group, a sec-butoxy group, a t-butoxy group, a n-pentoxy group, an i-pentoxy group, a sec-pentoxy group, a n-hexoxy group, an i-hexoxy group, a 1,1-dimethylpropyloxy group, a 1,2-dimethylpropyloxy group, a 2,2-dimethylpropyloxy group, a 1-methyl-2-ethylpropyloxy group, a 1-ethyl-2-methylpropyloxy group, a 1,1,2-trimethylpropyloxy group, a 1,2,2-trimethylpropyloxy group, a 1,1-dimethylbutyloxy group, a 1,2-dimethylbutyloxy group, a 2,2-dimethylbutyloxy group, a 2,3-dimethylbutyloxy group, a 1,3-dimethylbutyloxy group, a 2-ethylbutyloxy group, a 2-methylpentyloxy group, or a 3-methylpentyloxy group; a "C₃₋₁₈ alicyclic oxy group", such as a cyclopropyloxy group, a cyclobutyloxy group, a cyclopentyloxy group, a cyclohexyloxy group, a cycloheptyloxy group, a cyclooctyloxy group, a 1-methylcyclopentyloxycarbonylmethoxy group, a 1-ethylcyclohexyloxycarbonylmethoxy group, or a 1-methyladamantyloxycarbonylmethoxy group; a "C₆₋₁₈ aryloxy group", such as a phenyloxy group, a 1-naphthyloxy group, a 2-naphthyloxy group, an azulenyloxy group, a pentalenyloxy group, a heptalenyloxy group, an indacenyloxy group, an acenaphthyloxy group, a phenanthrenyloxy group, or an anthracenyloxy group; or the like.

In the "C₁₋₁₈ hydrocarbyloxy group", a divalent carbon atom at any position excluding the terminals in the "C₁₋₁₈ hydrocarbyl group" is preferably replaced by -O-, -C(=O)-, and/or -C(=O)O-, the "C₁₋₁₈ hydrocarbyloxy group" is more preferably a "C₁₋₁₈ hydrocarbyloxycarbonylalkyloxy group", and from the perspective of solubility, a carbon atom bonded to the oxygen atom of the hydrocarbyloxy is still more preferably a tertiary carbon. Specific examples of the hydrocarbyloxy include optionally substituted ethylcyclopentyloxy, methyladamantyloxy, ethyladamantyloxy, t-butyloxy, and the like.

The term "C₁₋₁₈ hydrocarbylcarbonyl group", as used herein, refers to a group in which a carbonyl group (-C(=O)-) is bonded to the "C₁₋₁₈ hydrocarbyl group".

The "C₁₋₁₈ hydrocarbylcarbonyl group" is, for example, but not limited to, a "C₁₋₁₈ alkylcarbonyl group", such as an acetyl group, a propionyl group, an isopropionyl group, a butyryl group, an isobutyryl group, a valeryl group, an isovaleryl group, a pentanoyl group, a 3-methylbutanoyl group, a pivaloyl group, a hexanoyl group, or a heptanoyl group; a "C₃₋₁₈ alicycliccarbonyl group", such as a cyclopropyl carbonyl group, a cyclobutyl carbonyl group, a cyclopentyl carbonyl group, a 2-methylcyclopentyl carbonyl group, a 3-methylcyclopentyl carbonyl group, a cyclohexyl carbonyl group, a 2-methylcyclohexyl carbonyl group, a 3-methylcyclohexyl carbonyl group, a 4-methylcyclohexyl carbonyl group, or an adamantyl carbonyl group; a "C₆₋₁₈ arylcarbonyl group", such as a benzoyl group, a 1-naphthoyl group, or a 2-naphthoyl group; or the like.

The term "C₁₋₁₈ hydrocarbylcarbonyloxy group", as used herein, refers to a group in which an oxygen atom (-O-) is bonded to the "C₁₋₁₈ hydrocarbylcarbonyl group".

The "C₁₋₁₈ hydrocarbylcarbonyloxy group" is, for example, but not limited to, a "C₁₋₁₈ alkylcarbonyloxy group", such as a methyl carbonyloxy group, an ethyl carbonyloxy group, a n-propyl carbonyloxy group, an isopropyl carbonyloxy group, a n-butyl carbonyloxy group, an isobutyl carbonyloxy group, a t-butyl carbonyloxy group, a n-pentyl carbonyloxy group, an isopentyl carbonyloxy group, or a hexyl carbonyloxy group; a "C₃₋₁₈ alicycliccarbonyloxy group", such as a cyclopropyl carbonyloxy group, a cyclobutyl carbonyloxy group, a cyclopentyl carbonyloxy group, or a cyclohexyl carbonyloxy group; a "C₆₋₁₈ arylcarbonyloxy group", such as a phenyl carbonyloxy group, a naphthyl carbonyloxy group, an acenaphthyl carbonyloxy group, a phenanthrenyl carbonyloxy group, or an anthracenyl carbonyloxy group; or the like.

The term "C₁₋₁₈ hydrocarbyloxycarbonyl group", as used herein, refers to a group in which a carbonyl group (-C(=O)-) is bonded to a "C₁₋₁₈ hydrocarbyloxy group".

The "C₁₋₁₈ hydrocarbyloxycarbonyl group" is, for example, but not limited to, a "C₁₋₁₈ alkoxycarbonyl group", such as a methoxycarbonyl group, an ethoxycarbonyl group, a n-propoxycarbonyl group, an i-propoxycarbonyl group, a n-butoxycarbonyl group, an i-butoxycarbonyl group, a sec-butoxycarbonyl group, a t-butoxycarbonyl group, a n-pentoxycarbonyl group, or a neopentyloxycarbonyl group; a "C₃₋₁₈ alicyclicoxycarbonyl group", such as a cyclopropyloxycarbonyl group, a cyclobutyloxycarbonyl group, a cyclopentyloxycarbonyl group, a cyclohexyloxycarbonyl group, a 2-methylcyclopentyloxycarbonyl group, a 3-methylcyclopentyloxycarbonyl group, a 2-methylcyclohexyloxycarbonyl group, a 3-methylcyclohexyloxycarbonyl group, or a 4-methylcyclohexyloxycarbonyl group; a "C₆₋₁₈ aryloxycarbonyl group", such as a phenoxycarbonyl group, a naphthoxycarbonyl group, an acenaphthyloxycarbonyl group, a phenanthrenyloxycarbonyl group, or an anthracenyloxycarbonyl group; or the like.

The term "C₁₋₁₈ hydrocarbyloxycarbonyloxy group", as used herein, refers to a group in which an oxygen atom (-O-) is bonded to the "C₁₋₁₈ hydrocarbyloxycarbonyl group".

The "C₁₋₁₈ hydrocarbyloxycarbonyloxy group" is, for example, but not limited to, a "C₁₋₁₈ alkoxycarbonyloxy group", such as a methoxycarbonyloxy group, an ethoxycarbonyloxy group, a n-propyloxycarbonyloxy group, an i-propyloxycarbonyloxy group, a n-butoxycarbonyloxy group, an i-butoxycarbonyloxy group, a sec-butoxycarbonyloxy group, a t-butoxycarbonyloxy group, a n-pentyloxycarbonyloxy group, an i-pentyloxycarbonyloxy group, or a n-hexyloxycarbonyloxy group; a "C₃₋₁₈ alicyclic oxycarbonyloxy group", such as a cyclopropyloxycarbonyloxy group, a cyclobutyloxycarbonyloxy group, a cyclopentyloxycarbonyloxy group, or a cyclohexyloxycarbonyloxy group; a "C₆₋₁₈ aryloxycarbonyloxy group", such as a phenoxycarbonyloxy group, a naphthoxycarbonyloxy group, an acenaphthyloxycarbonyloxy group, a phenanthrenyloxycarbonyloxy group, or an anthracenyloxycarbonyloxy group; or the like.

The term "C₁₋₁₈ hydrocarbylamino group", as used herein, refers to a group in which one "C₁₋₁₈ hydrocarbyl group" is bonded to an amino group.

The "C₁₋₁₈ hydrocarbylamino group" is, for example, but not limited to, a "C₁₋₁₈ alkylamino group", such as a methylamino group, an ethylamino group, a n-propylamino group, an i-propylamino group, a n-butylamino group, an i-butylamino group, a sec-butylamino group, a t-butylamino group, a n-pentylamino group, an i-pentylamino group, a neopentylamino group, or a n-hexylamino group; a "C₃₋₁₈ alicyclic amino group", such as a cyclopropylamino group, a cyclobutylamino group, a cyclopentylamino group, a 2-methylcyclopentylamino group, a 3-methylcyclopentylamino group, a cyclohexylamino group, a 2-methylcyclohexylamino group, a 3-methylcyclohexylamino group, or a 4-methylcyclohexylamino group; a "C₆₋₁₈ arylamino group", such as a phenylamino group, a 1-naphthylamino group, or a 2-naphthylamino group; or the like.

The term "di-C₁₋₁₈ hydrocarbylamino group", as used herein, refers to a group in which two identical or different "C₁₋₁₈ hydrocarbyl groups" are bonded to an amino group.

The "di-C₁₋₁₈ hydrocarbylamino group" is, for example, but not limited to, a "di-C₁₋₁₈ alkylamino group", such as a dimethylamino group, a diethylamino group, a di-n-propylamino group, a diisopropylamino group, a di-n-butylamino group, a diisobutylamino group, a di-t-butylamino group, a di-n-pentylamino group, a di-n-hexylamino group, an N-ethyl-N-methylamino group, an N-methyl-N-n-propylamino group, an N-isopropyl-N-methylamino group, an N-n-butyl-N-methylamino group, an N-isobutyl-N-methylamino group, an N-t-butyl-N-methylamino group, an N-methyl-N-n-pentylamino group, an N-n-hexyl-N-methylamino group, an N-ethyl-N-n-propylamino group, an N-ethyl-N-isopropylamino group, an N-n-butyl-N-ethylamino group, an N-ethyl-N-isobutylamino group, an N-t-butyl-N-ethylamino group, an N-ethyl-N-n-pentylamino group, or an N-ethyl-N-n-hexylamino group; a "di-C₃₋₁₈ alicyclic amino group", such as a dicyclopropylamino group, a dicyclobutylamino group, a dicyclopentylamino group, or a dicyclohexylamino group; a "di-C₆₋₁₈ arylamino group", such as a diphenylamino group or a phenylnaphthylamino group; an "N-C₁₋₁₈ alkyl-N-C₃₋₁₈ cycloalkylamino group", such as an N-methylcyclopentaneamino group or an N-methylcyclohexylamino group; an "N-C₁₋₁₈ alkyl-N-C₆₋₁₈ arylamino group", such as an N-methyl-2-phenylethylamino group or an N-ethyl-N-(4-methylphenyl)amino group; or the like.

The term "C₁₋₁₈ hydrocarbylaminocarbonyl group", as used herein, refers to a group in which a carbonyl group (-C(=O)-) is bonded to the "C₁₋₁₈ hydrocarbylamino group".

The "C₁₋₁₈ hydrocarbylaminocarbonyl group" is, for example, but not limited to, a "C₁₋₁₈ alkylaminocarbonyl group", such as a methylaminocarbonyl group, an ethylaminocarbonyl group, a n-propylaminocarbonyl group, an i-propylaminocarbonyl group, a n-butylaminocarbonyl group, a sec-butylaminocarbonyl group, a t-butylaminocarbonyl group, a n-pentylaminocarbonyl group, a 2-pentylaminocarbonyl group, a neopentylaminocarbonyl group, a 4-methyl-2-pentylaminocarbonyl group, a n-hexylaminocarbonyl group, or a 3-methyl-n-pentylaminocarbonyl group; a "C₃₋₁₈ alicyclic aminocarbonyl group", such as a cyclopropylaminocarbonyl group, a cyclobutylaminocarbonyl group, a cyclopentylaminocarbonyl group, a cyclohexylaminocarbonyl group, a 2-methylcyclopentylaminocarbonyl group, a 3-methylcyclopentylaminocarbonyl group, a 2-methylcyclohexylaminocarbonyl group, a 3-methylcyclohexylaminocarbonyl group, or a 4-methylcyclohexylaminocarbonyl group; or a "C₆₋₁₈ arylaminocarbonyl group", such as a phenylaminocarbonyl group, a 1-naphthylaminocarbonyl group, or a 2-naphthylaminocarbonyl group.

The term "di-C₁₋₁₈ hydrocarbylaminocarbonyl group", as used herein, refers to a group in which a carbonyl group (-C(=O)-) is bonded to a "di-C₁₋₁₈ hydrocarbylamino group".

The "di-C₁₋₁₈ hydrocarbylaminocarbonyl group" is, for example, but not limited to, a "di-C₁₋₁₈ alkylamino group", such as a dimethylaminocarbonyl group, a diethylaminocarbonyl group, a di-n-propylaminocarbonyl group, a diisopropylaminocarbonyl group, a di-n-butylaminocarbonyl group, a diisobutylaminocarbonyl group, a di-t-butylaminocarbonyl group, a di-n-pentylaminocarbonyl group, a di-n-hexylaminocarbonyl group, an N-ethyl-N-methylaminocarbonyl group, an N-methyl-N-n-propylaminocarbonyl group, an N-isopropyl-N-methylaminocarbonyl group, an N-n-butyl-N-methylaminocarbonyl group, an N-isobutyl-N-methylaminocarbonyl group, an N-t-butyl-N-methylaminocarbonyl group, an N-methyl-N-n-pentylaminocarbonyl group, an N-n-hexyl-N-methylaminocarbonyl group, an N-ethyl-N-n-propylaminocarbonyl group, an N-ethyl-N-isopropylaminocarbonyl group, an N-n-butyl-N-ethylaminocarbonyl group, an N-ethyl-N-isobutylaminocarbonyl group, an N-t-butyl-N-ethylaminocarbonyl group, an N-ethyl-N-n-pentylaminocarbonyl group, or an N-ethyl-N-n-hexylaminocarbonyl group; a "di-C₃₋₁₈ alicyclicaminocarbonyl group", such as a dicyclopropylaminocarbonyl group, a dicyclobutylaminocarbonyl group, a dicyclopentylaminocarbonyl group, or a dicyclohexylaminocarbonyl group; a "di-C₆₋₁₈ arylaminocarbonyl group", such as a diphenylaminocarbonyl group or a phenylnaphthylaminocarbonyl group; or the like.

The term "C₁₋₁₈ hydrocarbylcarbonylamino group", as used herein, refers to a group in which an amino group is bonded to the "C₁₋₁₈ hydrocarbylcarbonyl group".

The "C₁₋₁₈ hydrocarbylcarbonylamino group" is, for example, but not limited to, a "C₁₋₁₈ alkyl carbonylamino group", such as a methyl carbonylamino group, an ethyl carbonylamino group, a n-propyl carbonylamino group, an i-propyl carbonylamino group, a n-butyl carbonylamino group, an i-butyl carbonylamino group, a sec-butyl carbonylamino group, a t-butyl carbonylamino group, a n-pentyl carbonylamino group, an i-pentyl carbonylamino group, or a n-hexyl carbonylamino group; a "C₃₋₁₈ alicyclic carbonylamino group", such as a cyclopropyl carbonylamino group, a cyclobutyl carbonylamino group, a cyclopentyl carbonylamino group, or a cyclohexyl carbonylamino group; a "C₆₋₁₈ aryl carbonylamino group", such as a phenyl carbonylamino group, a naphthyl carbonylamino group, an acenaphthyl carbonylamino group, a phenanthrenyl carbonylamino group, or an anthracenyl carbonylamino group; or the like.

The term "C₁₋₁₈ hydrocarbylaminocarbonyloxy group", as used herein, refers to a group in which an oxygen atom (-O-) is bonded to the "C₁₋₁₈ hydrocarbylaminocarbonyl group".

The "C₁₋₁₈ hydrocarbylaminocarbonyloxy group" is, for example, but not limited to, a "C₁₋₁₈ alkylaminocarbonyloxy group", such as a methylaminocarbonyloxy group, an ethylaminocarbonyloxy group, or a n-propylaminocarbonyloxy group; a "C₃₋₁₈ alicyclic aminocarbonyloxy group", such as a cyclopropylaminocarbonyloxy group or a cyclohexylaminocarbonyloxy group; a "C₆₋₁₈ arylaminocarbonyloxy group", such as a phenylaminocarbonyloxy group or a 1-naphthylaminocarbonyloxy group; or the like.

The term "di-C₁₋₁₈ hydrocarbylaminocarbonyloxy group", as used herein, refers to a group in which an oxygen atom (-O-) is bonded to the "di-C₁₋₁₈ hydrocarbylaminocarbonyl group".

The "di-C₁₋₁₈ hydrocarbylaminocarbonyloxy group" is, for example, but not limited to, a "di-C₁₋₁₈ alkylaminocarbonyloxy group", such as a dimethylaminocarbonyloxy group, a diethylaminocarbonyloxy group, or a di-n-propylaminocarbonyloxy group; or the like.

The term "C₁₋₁₈ hydrocarbylaminocarbonylamino group", as used herein, refers to a group in which the "C₁₋₁₈ hydrocarbylaminocarbonyl group" is bonded to an amino group.

The "C₁₋₁₈ hydrocarbylaminocarbonylamino group" is, for example, but not limited to, a "C₁₋₁₈ alkylaminocarbonylamino group", such as a methylaminocarbonylamino group, an ethylaminocarbonylamino group, or a n-propylaminocarbonylamino group; a "C₃₋₁₈ alicyclic aminocarbonylamino group", such as a cyclopropylaminocarbonylamino group or a cyclohexylaminocarbonylamino group; a "C₆₋₁₈ arylaminocarbonylamino group", such as a phenylaminocarbonylamino group or a 1-naphthylaminocarbonylamino group; or the like.

The term "di-C₁₋₁₈ hydrocarbylaminocarbonylamino group", as used herein, refers to a group in which a "di-C₁₋₁₈ hydrocarbylaminocarbonyl group" is bonded to an amino group.

The "di-C₁₋₁₈ hydrocarbylaminocarbonylamino group" is, for example, but not limited to, a "di-C₁₋₁₈ alkylaminocarbonylamino group", such as a dimethylaminocarbonylamino group, a diethylaminocarbonylamino group, or a di-n-propylaminocarbonylamino group; or the like.

The term "C₁₋₁₈ hydrocarbyloxycarbonylamino group", as used herein, refers to a group in which the "C₁₋₁₈ hydrocarbyloxycarbonyl group" is bonded to an amino group.

The "C₁₋₁₈ hydrocarbyloxycarbonylamino group" is, for example, but not limited to, a "C₁₋₁₈ alkoxycarbonylamino group", such as a methoxycarbonylamino group, an ethoxycarbonylamino group, a n-propoxycarbonylamino group, an i-propoxycarbonylamino group, a n-butoxycarbonylamino group, or a t-butoxycarbonylamino group; a "C₃₋₁₈ alicyclic oxycarbonylamino group", such as a cyclopropyloxycarbonylamino group or a cyclohexyloxycarbonylamino group; a "C₆₋₁₈ aryloxycarbonylamino group", such as a phenyloxycarbonylamino group or a 1-naphthyloxycarbonylamino group; or the like.

The term "C₁₋₁₈ hydrocarbylthio group", as used herein, refers to a group in which a sulfur atom (-S-) is bonded to the "C₁₋₁₈ hydrocarbyl group".

The "C₁₋₁₈ hydrocarbylthio group" is, for example, but not limited to, a "C₁₋₁₈ alkylthio group", such as a methylthio group, an ethylthio group, a n-propylthio group, an i-propylthio group, a n-butylthio group, an i-butylthio group, a t-butylthio group, a n-pentylthio group, or a n-hexylthio group; a "C₃₋₁₈ alicyclic thio group", such as a cyclopropylthio group, a cyclobutylthio group, a cyclopentylthio group, a cyclohexylthio group, a 2-methylcyclopentylthio group, a 3-methylcyclopentylthio group, a 2-methylcyclohexylthio group, a 3-methylcyclohexylthio group, or a 4-methylcyclohexylthio group; a "C₆₋₁₈ arylthio group", such as a phenylthio group, a 1-naphthylthio group, a 2-naphthylthio group, an acenaphthylthio group, a phenanthrenylthio group, or an anthracenylthio group; or the like.

The term "C₁₋₁₈ hydrocarbylsulfinyl group", as used herein, refers to a group in which a sulfinyl group (-S(=O)-) is bonded to the "C₁₋₁₈ hydrocarbyl group".

The "C₁₋₁₈ hydrocarbylsulfinyl group" is, for example, but not limited to, a "C₁₋₁₈ alkylsulfinyl group", such as a methylsulfinyl group, an ethylsulfinyl group, a n-propylsulfinyl group, an i-propylsulfinyl group, a n-butylsulfinyl group, a t-butylsulfinyl group, a pentylsulfinyl group, or a hexylsulfinyl group; a "C₃₋₁₈ alicyclic sulfinyl group", such as a cyclopropylsulfinyl group, a cyclobutylsulfinyl group, a cyclopentylsulfinyl group, a cyclohexylsulfinyl group, a 2-methylcyclopentylsulfinyl group, a 3-methylcyclopentylsulfinyl group, a 2-methylcyclohexylsulfinyl group, a 3-methylcyclohexylsulfinyl group, or a 4-methylcyclohexylsulfinyl group; a "C₆₋₁₈ arylsulfinyl group", such as a phenylsulfinyl group, a naphthylsulfinyl group, an acenaphthylsulfinyl group, a phenanthrenylsulfinyl group, or an anthracenylsulfinyl group; or the like.

The term "C₁₋₁₈ hydrocarbylsulfonyl group", as used herein, refers to a group in which a sulfonyl group (-SO₂-) is bonded to the "C₁₋₁₈ hydrocarbyl group".

The "C₁₋₁₈ hydrocarbylsulfonyl group" is, for example, but not limited to, a "C₁₋₁₈ alkylsulfonyl group", such as a methylsulfonyl group, an ethylsulfonyl group, a n-propylsulfonyl group, an i-propylsulfonyl group, a n-butylsulfonyl group, a t-butylsulfonyl group, or a pentylsulfonyl group; a "C₃₋₁₈ alicyclic sulfonyl group", such as a cyclopropylsulfonyl group, a cyclobutylsulfonyl group, a cyclopentylsulfonyl group, a cyclohexylsulfonyl group, a 2-methylcyclopentylsulfonyl group, a 3-methylcyclopentylsulfonyl group, a 2-methylcyclohexylsulfonyl group, a 3-methylcyclohexylsulfonyl group, or a 4-methylcyclohexylsulfonyl group; a "C₆₋₁₈ arylsulfonyl group", such as a phenylsulfonyl group, a naphthylsulfonyl group, an acenaphthylsulfonyl group, a phenanthrenylsulfonyl group, or an anthracenylsulfonyl group; or the like.

In the present specification, the term "acid-dissociable group" refers to a group that substitutes for a hydrogen atom of a polar group, such as a hydroxy group (including a phenolic hydroxy group or the like), a carboxy group, an amino group, a sulfo group, or the like, and that is dissociated by the action of an acid.

In a compound having the above acid-dissociable group, the acid-dissociable group can be dissociated by the action of an acid to generate the polar group, thus increasing polarity of the compound. This enables solubility of the compound in a developer to be changed. More specifically, when a highly polar developer such as an alkaline aqueous solution is used as the developer, solubility of the compound in the developer relatively increases, whereas, when a low-polarity organic developer is used as the developer, solubility of the compound in the developer relatively decreases.

The polar group is preferably a hydroxy group (including a phenolic hydroxy group or the like) or a carboxy group.

The acid-dissociable group is not particularly limited, and a known and commonly used acid-dissociable group usable for a chemically amplified resist can be used. Examples of the acid-dissociable group include an acid-dissociable group G for polar groups having an acid-dissociable group and represented by the following general formula (G-1) to (G-4).

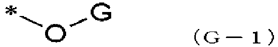

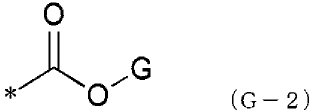

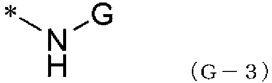

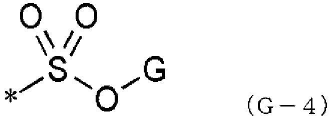

The acid-dissociable group G is not particularly limited, provided that it can be dissociated by the action of an acid, and may be a known and commonly used group. The acid-dissociable group G is, for example, a "tertiary-carbon-type acid-dissociable group G_{A}" represented by the following general formula (g-1), an "allyl- or benzyl-type acid-dissociable group G_{B}" represented by the following general formula (g-2), an "acetal-type acid-dissociable group G_{C}" represented by the following general formula (g-3), an "aminocarbonyl-type acid-dissociable group G_{D}" represented by the following general formula (g-4), or the like. Each of them will be sequentially described below.

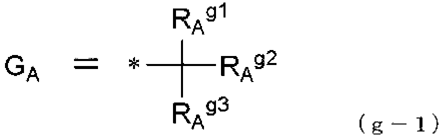

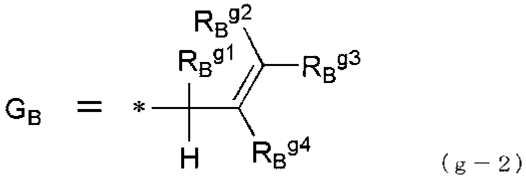

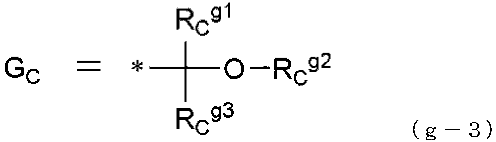

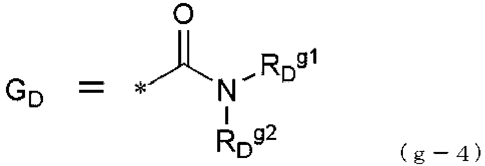

### <Tertiary-carbon-type Acid-Dissociable Group G_{A}>

As the acid-dissociable group G, an acid-dissociable group in which a carbon that is directly bonded to a polar group and to which R_{A}^{g1} to R_{A}^{g3} are bonded is a tertiary carbon atom, such as a "tertiary-carbon-type acid-dissociable group G_{A}" represented by the following general formula (g-1), can be used.

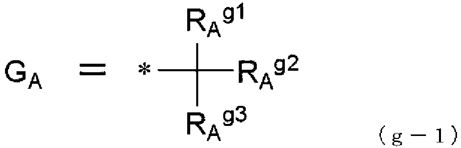

"R_{A}^{g1}" denotes an optionally substituted C₁₋₁₂ hydrocarbyl group in which any divalent carbon atom except the terminal positions may be replaced by -O-, -C(=O)-, -C(=O)O-, -OCO-, -CONH-, -NHCO-, -S-, or -SO₂-(provided that adjacent divalent carbon atoms are not replaced at the same time).

R_{A}^{g1} preferably denotes a C₁₋₁₂ alkyl group, a C₃₋₁₂ alicyclic group, a C₆₋₁₂ aryl group, or a C₇₋₁₂ aralkyl group each optionally having a substituent and any divalent carbon atom except the terminal positions may be replaced by -O-, -C(=O)-, -C(=O)O-, -OCO-, -CONH-, -NHCO-, -S-, or -SO₂- (provided that adjacent divalent carbon atoms are not replaced at the same time),
more preferably a C₁₋₁₂ alkyl group or a C₃₋₁₂ alicyclic group each optionally having a substituent and any divalent carbon atom except the terminal positions may be replaced by -O-, -C(=O)-, -C(=O)O-, -OCO-, -CONH-, -NHCO-, -S-, or -SO₂- (provided that adjacent divalent carbon atoms are not replaced at the same time).

"R_{A}^{g2}" and "R_{A}^{g3}" each independently denote an optionally substituted C₁₋₁₂ hydrocarbyl group, and a divalent carbon atom at any position except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time), or R_{A}^{g2} and R_{A}^{g3} may be combined to form a C₃₋₁₈ alicyclic group or a 3- to 18-membered non-aromatic heterocyclic group, each optionally having a substituent, and a divalent carbon atom at any position except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time).

In R_{A}^{g2} and R_{A}^{g3}, preferably, R_{A}^{g2} and R_{A}^{g3} may be combined to form a C₃₋₁₈ alicyclic group or a 3- to 18-membered non-aromatic heterocyclic group, each optionally having a substituent, and a divalent carbon atom at any position except the terminal positions may be substituted with -O-, -C(=O)-, -C(=O)O-, -OCO-, -CONH-, - NHCO-, -S-, or -SO₂- (provided that adjacent divalent carbon atoms are not substituted at the same time).

More preferably, the substituted C₃₋₁₈ alicyclic group or the 3- to 18-membered non-aromatic heterocyclic group, each optionally having a substituent, has a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, and a divalent carbon atom at any position except the terminal positions may be substituted with -O-, -C(=O)-, -C(=O)O-, -OCO-, -CONH-, - NHCO-, -S-, or -SO₂- (provided that adjacent divalent carbon atoms are not substituted at the same time).

A tertiary-carbon-type acid-dissociable group G_{A} represented by the general formula (g-1) is, for example, but not limited to, a t-butyl group, a t-amyl group, a 1,1-dimethylpropyl group, a 1-methyl-1-cyclopentyl group, a 1-ethyl-1-cyclopentyl group, a 1-methyl-1-cyclohexyl group, a 1-ethyl-1-cyclohexyl group, a 2-methyl-2-adamantyl group, a 2-ethyl-2-adamantyl group, a 1-(1-methoxy-2-methylpropan-2-yl)cyclopentyl group, a 1-(1-ethoxy-2-methylpropan-2-yl)cyclopentyl group, or the like.

### <<Tertiary-Carbon-Type Acid-Dissociable Group G_{A1} and G_{A2}>>

In the "tertiary-carbon-type acid-dissociable group G_{A}" represented by the general formula (g-1), the case where R_{A}^{g2} and R_{A}^{g3} may be combined to form a C₃₋₁₈ alicyclic group or a 3- to 18-membered non-aromatic heterocyclic group, each optionally having a substituent, is, for example, a tertiary-carbon-type acid-dissociable group G_{A1} represented by the following general formula (g-1-1), a tertiary-carbon-type acid-dissociable group G_{A2}>> represented by the following general formula (g-1-2), or the like.

### <<Tertiary-Carbon-Type Acid-Dissociable Group G_{A1} Represented by General Formula (g-1-1)>>

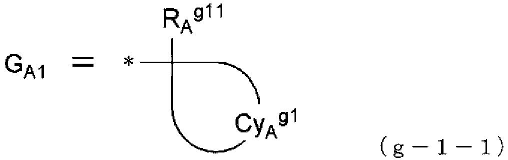

In the tertiary-carbon-type acid-dissociable group G_{A1} represented by the general formula (g-1-1), R_{A}^{g11} denotes a C₁₋₁₂ alkyl group, a C₃₋₁₂ alicyclic group, a C₆₋₁₂ aryl group, or a C₇₋₁₂ aralkyl group, each optionally having a substituent, and any divalent carbon atom except the terminal positions may be substituted with -O-, -C(=O)-, - C(=O)O-, -OCO-, -CONH-, -NHCO-, -S-, or -SO₂- (provided that adjacent divalent carbon atoms are not substituted at the same time).

Cy_{A}^{g1}, together with the tertiary carbon atom, forms a C₃₋₁₈ alicyclic group or a 3- to 18-membered non-aromatic heterocyclic group, each optionally having a substituent, and any divalent carbon atom may be substituted with -O-, -C(=O)-, -C(=O)O-, -OCO-, -CONH-, -NHCO-, -S-, or -SO₂- (provided that adjacent divalent carbon atoms are not substituted at the same time).

Preferably, Cy_{A}^{g1}, together with the tertiary carbon atom, forms a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, each optionally having a substituent, and a divalent carbon atom at any position except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

The tertiary-carbon-type acid-dissociable group G_{A1} represented by the general formula (g-1-1) is, for example, the following tertiary-carbon-type acid-dissociable group.

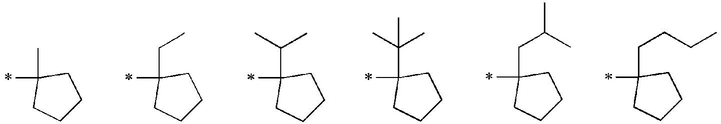

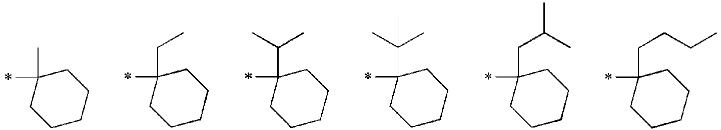

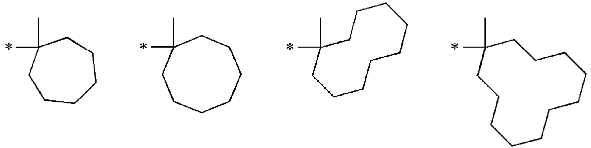

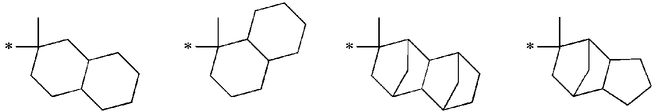

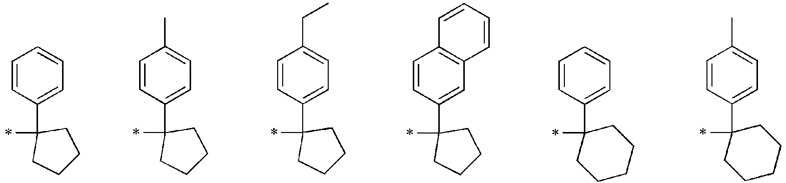

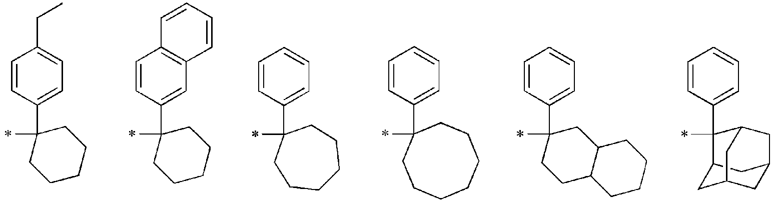

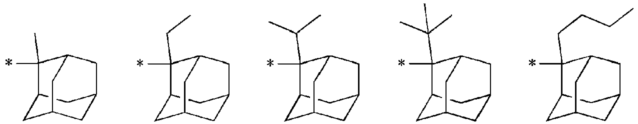

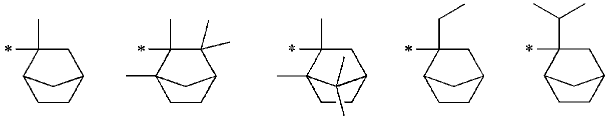

### <<Tertiary-Carbon-Type Acid-Dissociable Group G_{A2}>> Represented by General Formula (g-1-2)>>

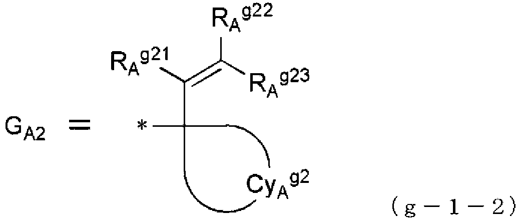

In the general formula (g-1-2), R_{A}^{g21} to R_{A}^{g23} each independently denote a hydro group or an optionally substituted C₁₋₁₂ hydrocarbyl group, any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time), and R_{A}^{g21} and RA^{g22}, and/or R_{A}^{g22} and R_{A}^{g23} may be directly bonded to each other by a single bond or may be bonded to each other via a divalent linker such as, -O-, -S-, -C(=O)-, -S(=O)-, - S(=O)₂-, -C(=O)O-, or a C₁₋₃ alkylene group, to form a ring.

The case where R_{A}^{g21} and R_{A}^{g22}, and/or R_{A}^{g22} and R_{A}^{g23} form a ring together with a carbon atom contained in the ethylenically unsaturated double bond is, for example, a case where they forms a cyclopentenyl group, a cyclohexenyl group, a cyclopentylidene ethenyl group, a cyclohexylidene ethenyl group, or the like, each optionally having a substituent.

Cy_{A}^{g2}, together with the tertiary carbon atom, forms a C₃₋₁₈ alicyclic group or a 3- to 18-membered non-aromatic heterocyclic group, each optionally having a substituent, and any divalent carbon atom may be substituted with -O-, -C(=O)-, -C(=O)O-, -OCO-, -CONH-, -NHCO-, -S-, or -SO₂- (provided that adjacent divalent carbon atoms are not substituted at the same time).

Preferably, Cy_{A}^{g2}, together with the tertiary carbon atom, forms a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, each optionally having a substituent, and a divalent carbon atom at any position except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

The tertiary-carbon-type acid-dissociable group G_{A2}>> represented by the general formula (g-1-2) is, for example, the following tertiary-carbon-type acid-dissociable group.

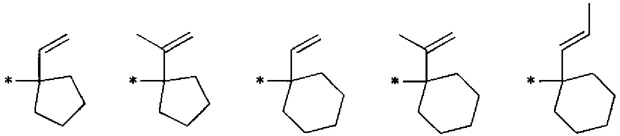

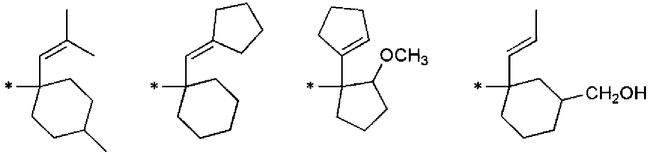

### <Allyl-Type or Benzyl-Type Acid-Dissociable Group G_{B}>

As the acid-dissociable group G, an acid-dissociable group in which a carbon that is directly bonded to a polar group corresponds to the allylic position or the benzylic position, such as an "allyl-type or benzyl-type acid-dissociable group G_{B}" represented by the following general formula (g-2), can be used.

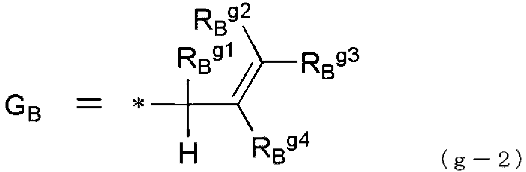

"R_{B}^{g1}" denotes an optionally substituted C₁₋₁₂ hydrocarbyl group in which any divalent carbon atom except the terminal positions may be replaced by -O-, -C(=O)-, -C(=O)O-, -OCO-, -CONH-, -NHCO-, -S-, or - SO₂- (provided that adjacent divalent carbon atoms are not replaced at the same time).

R_{B}^{g1} preferably denotes a C₁₋₁₂ alkyl group, a C₃₋₁₂ alicyclic group, a C₆₋₁₂ aryl group, or a C₇₋₁₂ aralkyl group each optionally having a substituent and any divalent carbon atom except the terminal positions may be replaced by -O-, -C(=O)-, -C(=O)O-, -OCO-, -CONH-, -NHCO-, -S-, or -SO₂- (provided that adjacent divalent carbon atoms are not replaced at the same time),
more preferably a C₁₋₁₂ alkyl group or a C₃₋₁₂ alicyclic group each optionally having a substituent and any divalent carbon atom except the terminal positions may be replaced by -O-, -C(=O)-, -C(=O)O-, -OCO-, -CONH-, -NHCO-, -S-, or -SO₂- (provided that adjacent divalent carbon atoms are not replaced at the same time).

"R_{B}^{g2}" to "R_{B}^{g4}" each independently denote a hydro group, or an optionally substituted C₁₋₁₂ hydrocarbyl group in which any divalent carbon atom except the terminal positions may be replaced by -O-, -C(=O)-, -C(=O)O-, -OCO-, -CONH-, -NHCO-, -S-, or -SO₂- (provided that adjacent divalent carbon atoms are not replaced at the same time).

R_{B}^{g1} and R_{B}^{g2}, R_{B}^{g2} and R_{B}^{g3}, and/or R_{B}^{g3} and R_{B}^{g4} may be linked to each other directly by a single bond or via divalent linking -O-, -S-, -C(=O)-, -S(=O)-, -S(=O)₂-, -C(=O)O-, or a C₁₋₃ alkylene group to form a ring.

In the allyl-type or benzyl-type acid-dissociable group G_{B} represented by general formula (g-2), the case where R_{B}²¹ and R_{B}^{g2}, R_{B}^{g2} and R_{B}^{g3}, and/or R_{B}^{g3} and R_{B}^{g4} form a ring together with a carbon atom contained in an ethylenically unsaturated double bond is, for example, a case where they form a cyclopentenyl group, a cyclohexenyl group, a cyclopentylidene ethenyl group, a cyclohexylidene ethenyl group, a benzyl group, a 2,3-dihydro-1H-indanyl group, or the like, each optionally having a substituent.

Examples of the allyl-type or benzyl-type acid-dissociable group G_{B} represented by general formula (g-2) include the following allyl-type or benzyl-type acid-dissociable groups.

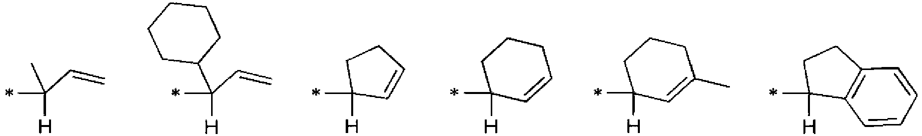

### <Acetal-type Acid-Dissociable Group G_{C}>

The acid-dissociable group G can be an acid-dissociable group in which an oxygen atom is bonded to a carbon atom directly bonded to a polar group, such as an "acetal-type acid-dissociable group G_{C}" represented by the following general formula (g-3).

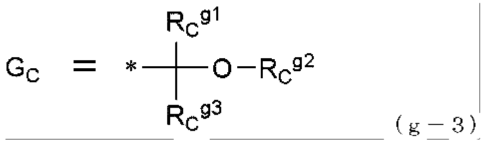

"R_{C}^{g1}" and "R_{C}^{g3}" each independently denote a hydro group, or an optionally substituted C₁₋₁₂ hydrocarbyl group in which any divalent carbon atom except the terminal positions may be replaced by -O-, - C(=O)-, -C(=O)O-, -OCO-, -CONH-, -NHCO-, -S-, or -SO₂- (provided that adjacent divalent carbon atoms are not replaced at the same time).

Preferably, R_{C}^{g1} and R_{C}^{g3} denote a hydro group, or a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time),
more preferably a hydro group, or a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

"R_{C}^{g2}" denotes an optionally substituted C₁₋₁₂ hydrocarbyl group in which any divalent carbon atom except the terminal positions may be replaced by -O-, -C(=O)-, -C(=O)O-, -OCO-, -CONH-, -NHCO-, -S-, or - SO₂- (provided that adjacent divalent carbon atoms are not replaced at the same time).

Preferably, R_{C}^{g2} denotes a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time),
more preferably a C₁₋₆ alkyl group or a C₃₋₈ alicyclic group, the alkyl group and the alicyclic group each optionally having a substituent, and any divalent carbon atom except the terminal positions may be substituted with -O-, - C(=O)-, -C(=O)O-, -OCO-, -CONH-, -NHCO-, -S-, or -SO₂- (provided that adjacent divalent carbon atoms are not substituted at the same time).

The acetal-type acid-dissociable group Gc represented by the general formula (g-3) is, for example, a methoxymethoxy group, an ethoxymethoxy group, a n-propoxymethoxy group, a n-butoxymethoxy group, a 2,2-dimethylpropoxymethoxy group, a 2,2-dimethylbutoxymethoxy group, a cyclohexyloxymethoxy group, a 1-ethoxyethoxy group, a 1-n-butoxyethoxy group, a 1-cyclohexyloxyethoxy group, or the like.

### <Aminocarbonyl-Type Acid-Dissociable Group G_{D}>

The acid-dissociable group G can be an acid-dissociable group in which an aminocarbonyl group is bonded to a polar group, such as an "aminocarbonyl-type acid-dissociable group G_{D}" represented by the following general formula (g-4).

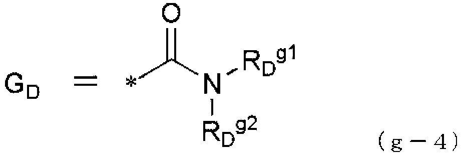

"R_{D}^{g1}" and "R_{D}^{g2}" each independently denote a hydro group, or an optionally substituted C₁₋₁₂ hydrocarbyl group in which any divalent carbon atom except the terminal positions may be replaced by -O-, - C(=O)-, -C(=O)O-, -OCO-, -CONH-, -NHCO-, -S-, or -SO₂- (provided that adjacent divalent carbon atoms are not replaced at the same time).

Preferably, R_{D}^{g1} and R_{D}^{g2} denote a hydro group, or a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time),
more preferably a hydro group, or a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

The aminocarbonyl-type acid-dissociable group G_{D} represented by the general formula (g-4) is, for example, a dimethylaminocarbonyl group, a diethylaminocarbonyl group, a diisopropylaminocarbonyl group, an N-phenyl-N-methyl-aminocarbonyl group, or the like.

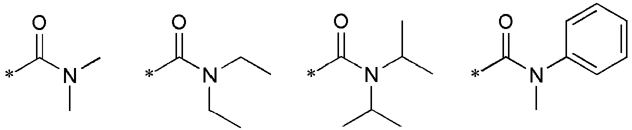

The term "a hydroxy or carboxy group having a protective group", as used herein, refers to a hydroxy or carboxy group in which the hydroxy group (including a phenolic hydroxy group) or the carboxy group is protected by an ether protective group, a silyl ether protective group, an acyl protective group, or the like.

The ether protective group is, for example, but not limited to, a methyl group, a benzyl group, a p-methoxybenzyl group, a t-butyl group, a triphenylmethyl group, a p-methoxyphenyldiphenylmethyl group, di(p-methoxyphenyl)phenylmethyl group, or the like.

The silyl ether protective group is, for example, but not limited to, a t-butyldimethylsilyl group (TBS), a triisopropylsilyl group (TIPS), a trimethylsilyl group (TMS), a triethylsilyl group (TES), a t-butyldiphenylsilyl group (TBDPS), or the like.

The acyl protective group is, for example, but not limited to, an acetyl group, a pivaloyl group, a benzoyl group, or the like.

The phrase "optionally substituted" or "optionally having a substituent", as used herein, is not particularly limited provided that it is chemically acceptable and has the advantages of the present invention.

The "substituent" is, for example, (1) a halogen atom, (2) a haloalkyl group, (3) a hydroxy group, (4) a thiol group, (5) a nitro group, (6) a cyano group, (7) a carboxy group, (8) an amino group, (9) a sulfo group, (10) a vinyl group, (11) an allyl group, (12) a (meth)acryloyl group, (13) a (meth)acryloyloxy group, (14) a (meth)acrylamide group, (15) a styryl group, (16) an epoxy group, (17) a glycidyl group, (18) an amide group, (19) a hydroxy group or a carboxy group each having a protective group, (20) a polar groups having an acid-dissociable group, or (21) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, a C₁₋₁₈ hydrocarbylthio group, a C₁₋₁₈ hydrocarbylsulfinyl group, or a C₁₋₁₈ hydrocarbylsulfonyl group, in which at least part of hydrogen atoms may be substituted with (1) to (20), and a divalent carbon atom at any position of these substituents except the terminal positions may be substituted with - O-, -C(=O)-, -C(=O)O-, -OCO-, -CONH-, -NHCO-, -NH(C=O)O-, -S-, or -SO₂- (provided that adjacent divalent carbon atoms are not substituted at the same time), or the like.

### [1. Resist Material]

A resist material according to the present embodiment contains (A) a heteropolyacid salt havin g a modified lacunary site or a mixture thereof.

(A^{m+})ₐ(Bⁿ⁺)_{b}(C^{(am+bn)-}) (I)

[In the formula (I),
A^{m+} each independently denotes H⁺, a metal ion, an ammonium cation, an ammonium dication , a phosphonium cation, or a phosphonium dication;
Bⁿ⁺ each independently denotes a sulfonium cation, a sulfonium dication, or an iodonium catio n, each having one or more polar groups each having an acid-dissociable group;
C^{(am+bn)-} denotes a heteropolyacid anion having a lacunary site in which the lacunary site is m odified; and
m denotes an integer in the range of 1 to 5, n denotes an integer of 1 or 2, a denotes a real number, and b denotes a real number greater than 0.]

Furthermore, the resist material according to the present embodiment may contain (B) an acid diffusion control agent as an optional component.

### [1-1. (A) Heteropolyacid Salt Having Modified Lacunary Site or Mixture Thereof]

The (A) heteropolyacid salt having a modified lacunary site or the mixture thereof can be a h eteropolyacid salt having a modified lacunary site represented by the general formula (I) or a mixture th ereof. The heteropolyacid salt having a modified lacunary site or the mixture thereof has an anion moie ty composed of a heteropolyacid anion having a lacunary site in which the lacunary site is modified. T he heteropolyacid salt having a modified lacunary site or the mixture thereof has a cation moiety compo sed of a sulfonium cation, a sulfonium dication, or an iodonium cation, each having one or more polar groups each having an acid-dissociable group.

### [1-1-1. Anion Moiety of Heteropolyacid Salt Having Modified Lacunary Site or Mixture Thereof]

The heteropolyacid salt having the modified lacunary site or the mixture thereof according to t he present embodiment has an anion moiety composed of a heteropolyacid anion having a lacunary site i n which the lacunary site is modified.

### [1-1-1-1. Heteropolyacid Anion Having Modified Lacunary Site]

The heteropolyacid anion having a lacunary site in which the lacunary site is modified can be a heteropolyacid anion having a modified lacunary site produced by reacting a terminal oxygen atom of the lacunary site in the heteropolyacid anion having the lacunary site with a P, Si, Ge, or Sn compoun d having one or more hydro groups or organic groups and two or more leaving groups.

### [1-1-1-1-1. Heteropolyacid Anion Having Lacunary Site]

The heteropolyacid anion having the lacunary site according to the present embodiment is not particularly limited and may be a lacunary species having a defect in part of the basic skeleton of the heteropolyacid anion, and any of a mono-lacunary species, a di-lacunary species, a tri-lacunary species, and the like may be used. The heteropolyacid anion having the lacunary site is, for example, a lacunary Keggin-type heteropolyacid anion, a lacunary Dawson-type heteropolyacid anion, or the like.

### [1-1-1-1-1-1. Lacunary Keggin-Type Heteropolyacid Anion]

The lacunary Keggin-type heteropolyacid anion is, for example, a mono-lacunary Keggin-type heteropolyacid anion represented by the following general formula (II-1), a di-lacunary Keggin-type heteropolyacid anion represented by the following general formula (II-2), a tri-lacunary Keggin-type heteropolyacid anion represented by the following general formula (II-3), or the like.

[XM₁₁O₃₉]^{c11-} (II-1)

[XM₁₀O₃₆]^{c12-} (II-2)

[XM₉O₃₄]^{c13-} (II-3)

(wherein
X denotes a heteroatom of P, Si, B, S, or Ge,
M denotes a polyatom of Mo, W, V, Nb, or Ta, and
c11- to c13- denote the number of negative charges, and c11 to c13 denote natural numbers.)

In the general formulae (II-1) to (II-3), the values of c11 to c13 vary with the types of X and M.

For example, in the general formula (II-1), when X denotes P and M denotes Mo or W, c11 is 7 ([PMo₁₁O₃₉]⁷⁻, [PW₁₁O₃₉]⁷⁻), when X denotes Si and M denotes Mo or W, c11 is 8 ([SiMo₁₁O₃₉]⁸⁻, [SiW₁₁O₃₉]⁸⁻), when X denotes S and M denotes Mo or W, c11 is 6 ([SMo₁₁O₃₉]⁶⁻, [SW₁₁O₃₉]⁶⁻), when X denotes B and M denotes Mo or W, c11 is 9 ([BMo₁₁O₃₉]⁹⁻, [BW₁₁O₃₉]⁹⁻), and when X denotes Ge and M denotes Mo or W, c11 is 8 ([GeMo₁₁O₃₉]⁸⁻, [GeW₁₁O₃₉]⁸⁻).

In the general formula (II-2), when X denotes P and M denotes Mo or W, c12 is 7 ([PMo₁₀O₃₆]⁷⁻, [PW₁₀O₃₆]⁷⁻), when X denotes Si and M denotes Mo or W, c12 is 8 ([SiMo₁₀O₃₆]⁸⁻, [SiW₁₀O₃₆]⁸⁻), when X denotes B and M denotes Mo or W, c12 is 9 ([BMo₁₀O₃₆]⁹⁻, [BW₁₀O₃₆]⁹⁻), and when X denotes Ge and M denotes Mo or W, c12 is 8 ([GeMo₁₀O₃₆]⁸⁻, [GeW₁₀O₃₆]⁸⁻).

In the general formula (II-3), for example, when X denotes P and M denotes Mo or W, c13 is 9 ([PMo₉O₃₄]⁹⁻, [PW₉O₃₄]⁹⁻), when X denotes Si and M denotes Mo or W, c13 is 10 ([SiMo₉O₃₄]¹⁰⁻, [SiW₉O₃₄]¹⁰⁻), when X denotes S and M denotes Mo or W, c13 is 8 ([SMo₉O₃₄]⁸⁻, [SW₉O₃₄]⁸⁻), and when X denotes Ge and M denotes Mo or W, c13 is 10 ([GeMo₉O₃₄]¹⁰⁻, [GeW₉O₃₄]¹⁰⁻).

The isomer structure of the lacunary Keggin-type heteropolyacid anion is preferably an α-form, a β-form, or a γ-form.

The isomer structure of the mono-lacunary Keggin-type heteropolyacid anion represented by the general formula (II-1) is preferably [α-PW₁₁O₃₉]⁷⁻, [β-PW₁₁O₃₉]⁷⁻, [γ-PW₁₁O₃₉]⁷⁻, [α-PMo₁₁O₃₉]⁷⁻, [β-PMo₁₁O₃₉]⁷⁻, [γ-PW₁₁O₃₉]⁷⁻, [α-SiW₁₁O₃₉]⁸⁻, [β-SiW₁₁O₃₉]⁸⁻, [γ-SiW₁₁O₃₉]⁸⁻, [α-SiMo₁₁O₃₉]⁸⁻, [β-SiMo₁₁O₃₉]⁸⁻, or [γ-SiW₁₁O₃₉]⁸⁻, more preferably [α-PW₁₁O₃₉]⁷⁻, [α-PMo₁₁O₃₉]⁷⁻, [α-SiW₁₁O₃₉]⁸⁻, or [α-SiMo₁₁O₃₉]⁸⁻.

The isomer structure of the di-lacunary Keggin-type heteropolyacid anion represented by the general formula (II-2) is preferably [α-PW₁₀O₃₆]⁷⁻, [β-PW₁₀O₃₆]⁷⁻, [γ-PW₁₀O₃₆]⁷⁻, [α-PMo₁₀O₃₆]⁷⁻, [β-PMo₁₀O₃₆]⁷⁻, [γ-PW₁₀O₃₆]⁷⁻, [α-SiW₁₀O₃₆]⁸⁻, [β-SiW₁₀O₃₆]⁸⁻, [γ-SiW₁₀O₃₆]⁸⁻, [α-SiMo₁₀O₃₆]⁸⁻, [β-SiMo₁₀O₃₆]⁸⁻, or [γ-SiW₁₀O₃₆]⁸⁻, more preferably [γ-PW₁₀O₃₆]⁷⁻, [γ-PMo₁₀O₃₆]⁷⁻, [γ-SiW₁₀O₃₆]⁸⁻, or [γ-SiMo₁₀O₃₆]⁸⁻.

The isomer structure of the tri-lacunary Keggin-type heteropolyacid anion represented by the general formula (II-3) is preferably [α-PW₉O₃₄]⁹⁻, [β-PW₉O₃₄]⁹⁻, [γ-PW₉O₃₄]⁹⁻, [α-PMo₉O₃₄]⁹⁻, [β-PMo₉O₃₄]⁹⁻, [γ-PW₉O₃₄]⁹⁻, [α-SiW₉O₃₄]¹⁰⁻, [β-SiW₉O₃₄]¹⁰⁻, [γ-SiW₉O₃₄]¹⁰⁻, [α-SiMo₉O₃₄]¹⁰⁻, [β-SiMo₉O₃₄]¹⁰⁻, or [γ-SiW₉O₃₄]¹⁰⁻.

### [1-1-1-1-1-2. Lacunary Dawson-Type Heteropolyacid Anion]

The lacunary Dawson-type heteropolyacid anion is, for example, a mono-lacunary Dawson-type heteropolyacid anion represented by the following general formula (III-1), a di-lacunary Dawson-type heteropolyacid anion represented by the following general formula (III-2), a tri-lacunary Dawson-type heteropolyacid anion represented by the following general formula (III-3), or the like.

[X₂M₁₇O₆₁]^{c21-} (III-1)

[X₂M₁₆O₅₈]^{c22-} (III-2)

[X₂M₁₅O₅₆]^{c23-} (III-3)

(wherein
X denotes a heteroatom of P, Si, B, S, or Ge,
M denotes a polyatom of Mo, W, V, Nb, or Ta, and
c21- to c23- denote the number of negative charges, and c21 to c23 denote natural numbers.)

In the general formulae (III-1) to (III-3), the values of c21 to c23 vary with the types of X and M.

For example, in the general formula (III-1), when X denotes P and M denotes Mo or W, c21 is 10 ([P₂Mo₁₇O₆₁]¹⁰⁻, [P₂W₁₇O₆₁]¹⁰⁻), and when X denotes S and M denotes W, c21 is 8 ([S₂W₁₇O₆₁]⁸⁻).

In the general formula (III-2), when X denotes Ge and M denotes Mo, c22 is 12 ([Ge₂Mo₁₆O₅₈]¹²⁻).

In the general formula (III-3), when X denotes P and M denotes Mo or W, c23 is 12 ([P₂Mo₁₅O₅₆]¹²⁻, [P₂W₁₅O₅₆]¹²⁻).

The isomer structure of the lacunary Dawson-type heteropolyacid anion is preferably an α-form, a β-form, or a γ-form.

The isomer structure of the lacunary Dawson-type heteropolyacid anion represented by the general formula (III-1), (III-2), or (III-3) is preferably [α-P₂W₁₇O₆₁]¹⁰⁻, [α-P₂W₁₅O₅₆]¹²⁻, [α-S₂W₁₇O₆₁]⁸⁻, or the like.

### [1-1-1-1-2. Modification of Lacunary site]

The lacunary site of the heteropolyacid anion having the lacunary site according to the present embodiment is modified by reacting a terminal oxygen atom of the lacunary site with a P, Si, Ge, or Sn compound having one or more hydro groups or organic groups and two or more leaving groups. In this reaction, the terminal oxygen atom of the lacunary site of the heteropolyacid anion is bonded to a g roup having a heteroatom of P, Si, Ge, or Sn bonded to one or more hydro groups or organic groups v ia a part or all of the heteroatom, whereby the lacunary site is modified.

### [1-1-1-1-2-1. Binding Form of Lacunary Site and Notation Thereof]

In the heteropolyacid anion having the modified lacunary site according to the present embodi ment, a terminal oxygen atom of the lacunary site in the heteropolyacid anion having the lacunary site i s modified by a group having one or more heteroatoms of P, Si, Ge, or Sn bonded to one or more hyd ro groups or organic groups.

The binding form between the terminal oxygen atom of the lacunary site of the heteropolyacid anion and the group having one or more heteroatoms of P, Si, Ge, or Sn bonded to one or more hydro groups or organic groups is not particularly limited and may be represented by, for example, the following general formulae (IV-1) to (IV-5). 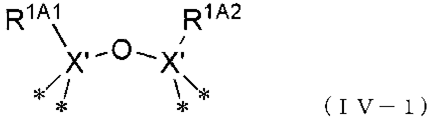 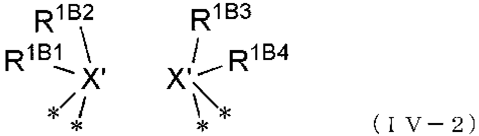 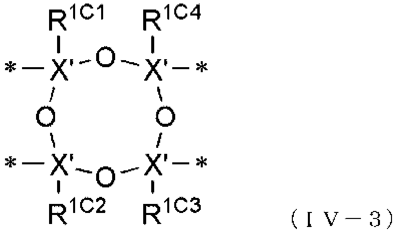 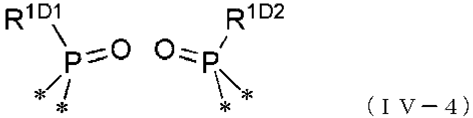 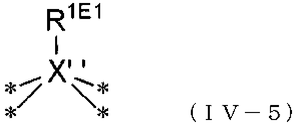 [In the formula (IV-1)~(IV-5)
X' denotes Si or Ge;
X" denotes a heteroatom of Si, Ge, or Sn;
R^{1A1} to R^{1E1} each independently denote a hydro groups or an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{1A1} to R^{1E1} excluding the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time),
a hydrogen atom in R^{1A1} to R^{1E1} may be substituted with, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and
* denotes a terminal oxygen atoms of the lacunary site.]

In the present description, for convenience, a heteropolyacid anion having a lacunary site modified with a group having a heteroatom of Si or Ge bonded to one or more hydro groups or organic groups represented by the general formula (IV-1) can be represented by the following general formula (V-1).

[X_{w}MₓO_{y}(R^{1A1}X')(R^{1A2}X')O]^{c-} (V-1)

(In the formula, w, x, y, and c all denote natural numbers, and X, M, X', R^{1A1}, and R^{1A2} are the same as above.)

When R^{1A1} and R^{1A2} are identical, they can be denoted as R^{1A} in the following general formula (V-1').

[X_{w}MₓO_{y}(R^{1A}X')₂O]^{c-} (V-1')

The heteropolyacid anion having the modified lacunary site represented by the general formula (V-1) or (V-1') is not particularly limited and may be produced by, for example, reacting a heteropolyacid anion having a lacunary site with (R^{1A})X'Y₃ (Y denotes a leaving group, for example, a halogen atom, a hydroxy group, an alkoxy group (preferably a C₁₋₄ alkoxy group, more preferably a C₁₋₂ alkoxy group), an alkylcarbonyloxy group (preferably a C₁₋₄ alkylcarbonyloxy group), a hydrocarbylsulfonyloxy group (preferably a C₁₋₆ alkylsulfonyloxy group or a C₇₋₁₀ aralkylsulfonyloxy group, for example, a methanesulfonyloxy group, a p-toluenesulfonyloxy group, or the like)).

Likewise, in the present description, for convenience, a heteropolyacid anion having a lacunary site modified with a group having one or more heteroatom of Si or Ge bonded to one or more hydro groups or organic groups represented by the general formula (IV-2) can be represented by the following general formula (V-2).

[X_{w}MₓO_{y}(R^{1B1}R^{1B2}X')(R^{1B3}R^{1B4}Si)]^{c-} (V-2)

(In the formula, w, x, y, and c all denote natural numbers, and X, M, X', R^{1B1}, R^{1B2}, R^{1B3}, and R^{1B4} are the same as above.)

When R^{1B1}R^{1B2} and R^{1B3}R^{1B4} are identical, they can be represented by the following general formula (V-2').

[X_{w}MₓO_{y}(R^{1B1}R^{1B2}X')₂]^{c-} (V-2')

The heteropolyacid anion having the modified lacunary site represented by the general formula (V-2) or (V-2') is not particularly limited and may be produced by, for example, reacting a heteropolyacid anion having a lacunary site with (R^{1B1})(R^{1B2})X'Y₂ (Y denotes a leaving group as described above).

In the present description, for convenience, a heteropolyacid anion having a lacunary site modified with a group having a heteroatom of Si or Ge bonded to one or more hydro groups or organic groups represented by the general formula (IV-3) can be represented by the following general formula (V-3).

[X_{w}MₓO_{y}(R^{1C1}X'O)(R^{1C2}X'O)(R^{1C3}X'O)(R^{1C4}X'O)]^{c-} (V-3)

(In the formula, w, x, y, and c all denote natural numbers, and X, M, X', R^{1C1}, R^{1C2}, R^{1C3}, and R^{1C4} are the same as above.)

When R^{1C1}, R^{1C2}, R^{1C3}, and R^{1C4} are identical, they can be denoted as R^{1C} in the following general formula (V-3').

[X_{w}MₓO_{y}(R^{1C}X'O)₄]^{c-} (V-3')

The heteropolyacid anion having the modified lacunary site represented by the general formula (V-3) or (V-3') is not particularly limited and may be produced by, for example, reacting a di-lacunary Keggin-type or Dawson-type heteropolyacid anion with R^{1C}X'Y₃ (Y denotes a leaving group as described above).

In the present description, for convenience, a heteropolyacid anion having a lacunary site modified with a group having a heteroatom of P bonded to one or more hydro groups or organic groups represented by the general formula (IV-4) can be represented by the following general formula (V-4).

[X_{w}MₓO_{y}(R^{1D1}P=O)(R^{1D2}P=O)]^{c-} (V-4)

(In the formula, w, x, y, and c all denote natural numbers, and X, M, X', R^{1D1}, and R^{1D2} are the same as above.)

When R^{1D1} and R^{1D2} are identical, they can be denoted as R^{1D} in the following general formula (V-4').

[X_{w}MₓO_{y}(R^{1D}P=O)₂]^{c-} (V-4')

The heteropolyacid anion having the modified lacunary site represented by the general formula (V-4) or (V-4') is not particularly limited and may be produced by, for example, reacting a heteropolyacid anion having a lacunary site with R^{1D}P(=O)Y₂ (Y denotes a leaving group as described above).

In the present description, for convenience, a heteropolyacid anion having a lacunary site modified with a group having one or more heteroatom of Si, Ge, or Sn bonded to one or more hydro groups or organic groups represented by the general formula (IV-5) can be represented by the following general formula (V-5).

[X_{w}MₓO_{y}(R^{1E1}X")]^{c-} (V-5)

(In the formula, w, x, y, and c all denote natural numbers, and X, M, X'', and R^{1E1} are the same as above.)

(V-5) may be represented by the following general formula (V-5') in some cases. Note that R^{1E} is defined in the same manner as R^{1E1}.

[X_{w}MₓO_{y}(R^{1E}X")]^{c-} (V-5')

The heteropolyacid anion having the modified lacunary site represented by the general formula (V-5) or (V-5') is not particularly limited and may be produced by, for example, reacting a heteropolyacid anion having a lacunary site with R^{1E}X"Y₃ (Y denotes a leaving group as described above).

Among the heteropolyacid anions having the modified lacunary site represented by the general formulae (V-1) to (V-5) and (V-1') to (V-5'), heteropolyacid anions having a modified lacunary site represented by the following general formulae (VI-1) to (VI-12) are preferred from the perspective of being relatively stable and capable of controlling the reactivity.

[XM₁₁O₃₉(R^{1A}X')₂O]^{c31-} (VI-1)

[XM₁₁O₃₉(R^{1B1}R^{1B2}X')₂]^{c31-} (VI-2)

[XM₁₁O₃₉(R^{1D}P=O)₂]^{c31-} (VI-3)

[XM₁₁O₃₉(R^{1E}X")]^{c31-} (VI-4)

[XM₁₀O₃₆(R^{1A}X')₂O]^{c32-} (VI-5)

[XM₁₀O₃₆(R^{1B1}R^{1B2}X')₂]^{c32-} (VI-6)

[XM₁₀O₃₆(R^{1C}X'O)₄]^{c32-} (VI-7)

[XM₁₀O₃₆(R^{1D}P=O)₂]^{c32-} (VI-8)

[X₂M₁₇O₆₁(R^{1A}X')₂O]^{c33-} (VI-9)

[X₂M₁₇O₆₁(R^{1B1}R^{1B2}X')₂]^{c33-} (VI-10)

[X₂M₁₇O₆₁(R^{1D}P=O)₂]^{c33-} (VI-11)

[X₂M₁₇O₆₁(R^{1E}X")]^{c33-} (VI-12)

(wherein
X denotes a heteroatom of P, Si, B, S, or Ge,
M denotes a polyatom of Mo, W, V, Nb, or Ta, and
X' denotes a heteroatom of Si or Ge;
X" denotes a heteroatom of Si, Ge, or Sn;
R^{1A} to R^{1E} each independently denote a hydro group, an optionally substituted C₁₋₁₈ hydrocarbyl group, an optionally substituted 3- to 18-membered non-aromatic heterocyclic group, or an optionally substituted 5- to 18-membered aromatic heterocyclic group,
   a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time),
a hydrogen atom in R^{1A} to R^{1E} may be substituted with, for example, (a) a halogen atom, (b) a C₁₋₃ haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and
c31, c32, and c33 denote natural numbers)

In the heteropolyacid anion having the modified lacunary site, since four terminal oxygen atoms of the lacunary site are modified, in general, the value of c31 is c11 - 4, the value of c32 is c12 - 4, and the value of c33 is c21 - 4.

On the other hand, for example, when the organic group contains an amino group and the amino group is protonated to be an ammonium cation, or when the organic group contains a carboxy group and the carboxy group is converted into a carboxy anion, the values of c31 to c33 are different from the above values.

### [1-1-2. Cation Moiety of Heteropolyacid Salt Having Modified Lacunary Site or Mixture Thereof]

The cation moiety of the heteropolyacid salt having the modified lacunary site or the mixture thereof according to the present embodiment can be a sulfonium cation, a sulfonium dication, or an iodo nium cation, each having one or more polar groups each having an acid-dissociable group (Bⁿ⁺). The s ulfonium cation, sulfonium dication, or iodonium cation, each having one or more polar groups each hav ing an acid-dissociable group, preferably exhibits both a function as a photoacid generator and a function of changing the solubility in a developer by the action of an acid. The heteropolyacid salt having a m odified lacunary site or the mixture thereof may contain another counter cation (A^{m+}) in a cation moiety thereof.

### [1-1-2-1. Sulfonium Cation, Sulfonium Dication, or Iodonium Cation Having One or More Polar Groups Each Having Acid-Dissociable Group (Bⁿ⁺)]

The sulfonium cation, sulfonium dication, or iodonium cation having one or more polar groups each having an acid-dissociable group according to the present embodiment can be an organic sulfoniu m cation, an organic sulfonium dication, or an organic iodonium cation having one or more polar groups each having an acid-dissociable group.

### [1-1-2-1-1. Organic Sulfonium Cation Having One or More Polar Groups Each Having Acid-Dissociable Group]

The organic sulfonium cation having one or more polar groups each having an acid-dissociable group is not particularly limited and may be a known and commonly used one. The organic sulfonium cation having one or more polar groups each having an acid-dissociable group is, for example, an orga nic sulfonium cation represented by the following general formula (VII-1).

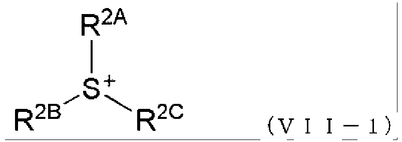

In general formula (VII-1), R^{2A}, R^{2B} and R^{2C} each independently represent a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R^{2A}, R^{2B} and R^{2C} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
a hydrogen atom in R^{2A}, R^{2B}, and R^{2C} may be substituted with (a) a halogen atom, (b) a hal oalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy gr oup, (q) a glycidyl group, (r) an amide group, (s) a hydroxy or carboxy group having a protective grou p, (t) a polar group having an acid-dissociable group, or (u) a C₁₋₁₈ hydrocarbyl group, a C₁₋₁₈ hydrocarb yloxy group, a C₁₋₁₈ hydrocarbylcarbonyl group, a C₁₋₁₈ hydrocarbylcarbonyloxy group, a C₁₋₁₈ hydrocarby loxycarbonyl group, a C₁₋₁₈ hydrocarbyloxycarbonyloxy group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(= O)-, -C(=O)O-, -OCO-, -CONH-, -NHCO-, -NH(C=O)O-, -S-, or -SO₂- (provided that adjacent divalent c arbon atoms are not substituted at the same time);
one or more hydrogen atoms in R^{2A} are substituted with the (t) polar group having an acid-di ssociable group, and
furthermore, any two of R^{2A}, R^{2B}, and R^{2C} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the formula (VII-1).

R^{2A} having one or more polar groups each having an acid-dissociable group preferably denotes a C₁₋₁₈ hydrocarbyl group optionally having a substituent;
a divalent carbon atom at any position of R^{2A} except the terminal positions may be substituted with -O-, -C(=O)-, -C(=O)O-, -OCO-, -CONH-, -NHCO-, -NH(C=O)O-, -S-, or -SO₂- (provided that adjacent dival ent carbon atoms are not substituted at the same time);
and at least one hydrogen atom of R^{2A} is substituted with the (t) polar group having an acid-dissociable group,
   more preferably a C₁₋₁₈ alkyl group, a C₃₋₁₈ alicyclic group, a C₆₋₁₈ aryl group, or a C₇₋₁₈ aral kyl group, each optionally having a substituent;
a divalent carbon atom at any position of R^{2A} except the terminal positions may be substituted with -O-, -C(=O)-, -C(=O)O-, -OCO-, -CONH-, -NHCO-, -NH(C=O)O-, -S-, or -SO₂- (provided that adjacent dival ent carbon atoms are not substituted at the same time);
and at least one hydrogen atom of R^{2A} is substituted with the (t) polar group having an acid-dissociable group,
   still more preferably a C₆₋₁₈ aryl group or a C₇₋₁₈ aralkyl group, each optionally having a subs tituent;
a divalent carbon atom at any position of R2A except the terminal positions may be substituted with -O -, -C(=O)-, -C(=O)O-, -OCO-, -CONH-, -NHCO-, -NH(C=O)O-, -S-, or -SO₂- (provided that adjacent div alent carbon atoms are not substituted at the same time);
and at least one hydrogen atom of R^{2A} is substituted with the (t) polar group having an acid-dissociable group.

R^{2A} is characterized by having one or more polar groups each having an acid-dissociable grou p; for example, it incorporates a polar group, such as a hydroxy group, a carboxy group, an amino grou p, or a sulfo group, each having an acid-dissociable group. The acid-dissociable group is, for example, a tertiary-carbon-type acid-dissociable group G_{A}, an allyl- or benzyl-type acid-dissociable group G_{B}, an ac etal-type acid-dissociable group Gc, an aminocarbonyl-type acid-dissociable group G_{D}, or the like.

R^{2A} having one or more polar groups each having an acid-dissociable group is, for example, t he following. * denotes a binding site with a sulfur atom in the general formula (VII-1).

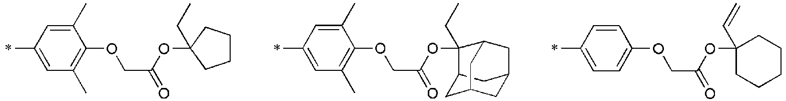

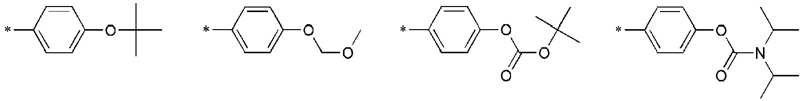

R^{2B} and R^{2C} are each independently preferably a C₁₋₁₈ hydrocarbyl group optionally having a substituent; in which a divalent carbon atom at any position of R^{2B} and R^{2C} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and a hydrogen atom contained in R^{2B} and R^{2C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{2B} and R^{2C} except the terminal positions may be substituted with -O-, -C(=O)-, -C(=O)O-, -OCO-, -CONH-, -NHCO-, -NH(C=O)O-, - S-, or -SO₂- (provided that adjacent divalent carbon atoms are not substituted at the same time); and a hydrogen atom contained in R^{2B} and R^{2C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time).

In the case where any two of R^{2A}, R^{2B}, and R^{2C} are linked to each other directly by a single bond or via a divalent linking group -O-, -S-, -C(=O)-, -S(=O)-, -S(=O)₂-, -C(=O)O-, or a C₁₋₃ alkylene group to form a ring together with the sulfur atom in formula (VII), the organic sulfonium cation is, for example, one having a thian-1-ium skeleton, a thiophen-1-ium skeleton, a 1,4-oxathian-4-ium skeleton, a 1,4-dithian-1-ium skeleton, a 1H-thiophen-1-ium skeleton, a benzo[b]thiophen-1-ium skeleton, a dibenzothiophenium skeleton, a 9,10-dihydrothioxanthylium skeleton, a 10H-phenoxathiin-10-ium skeleton, or a 5H-thianthren-5-ium skeleton, or the like, and examples thereof include the following. Note that * indicates a binding site to R^{2A}, R^{2B}, or R^{2C} which is not involved in formation of the ring.

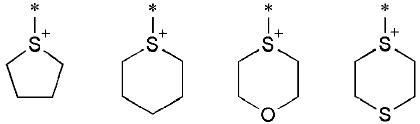

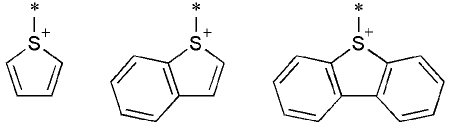

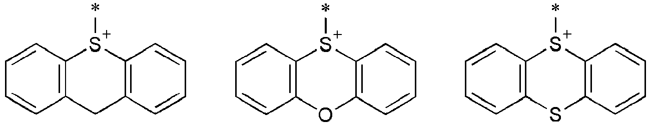

The organic sulfonium cation having one or more polar groups each having an acid-dissociable group is, for example, a (3,5-dimethyl-4-(2-((2-methyladamantan-2-yl)oxy)-2-oxoethoxy)phenyl)diphenylsulfonium cation, a (4-(2-((1-ethylcyclopentyl)oxy)-2-oxoethoxy)-3,5-dimethylphenyl)diphenylsulfonium cation, a (3,5-dimethyl-4-(2-((1-methylcyclopentyl)oxy)-2-oxoethoxy)phenyl)diphenylsulfonium cation, a 5-(2-(t-butoxy)-2-oxoethoxy)-3,5-dimethylphenyl)diphenylsulfonium cation, a (3,5-dimethyl-4-(2-(2-((2-methyladamantan-2-yl)oxy)-2-oxoethoxy)-2-oxoethoxy)phenyl)diphenylsulfonium cation, a 5-(3,5-dimethyl-4-(2-((2-methyladamantan-2-yl)oxy)-2-oxoethoxy)phenyl)-5H-dibenzo[b,d]thiophen-5-ium cation, a (4-(2-((1-ethylcyclohexyl)oxy)-2-oxoethoxy)-3,5-dimethylphenyl)diphenylsulfonium cation, a 1-(4-(2-((2-methyladamantan-2-yl)oxy)-2-oxoethoxy)naphthalen-1-yl)tetrahydro-1H-thiophen-1-ium cation, a (4-(t-butoxy)-3,5-dimethylphenyl)diphenylsulfonium cation, a (4-((diisopropylcarbamoyl)oxy)phenyl)dimethylsulfonium cation, a 1-(4-methoxymethoxy)naphthalen-1-yl)tetrahydro-1H-thiophen-1-ium cation, a 1-(2-((2-methyladamantan-2-yl)oxy)-2-oxoethyl)tetrahydro-1H-thiophen-1-ium cation, a 1-(2-((2-methyladamantan-2-yl)oxy)-2-oxoethyl)hexahydrothiopyrylium cation, or the like.

The organic sulfonium cation having one or more polar groups each having an acid-dissociable group is, for example, the following.

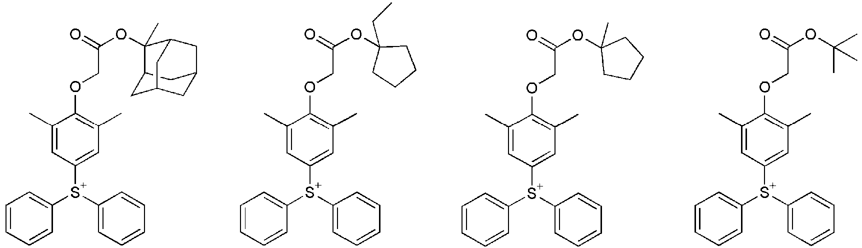

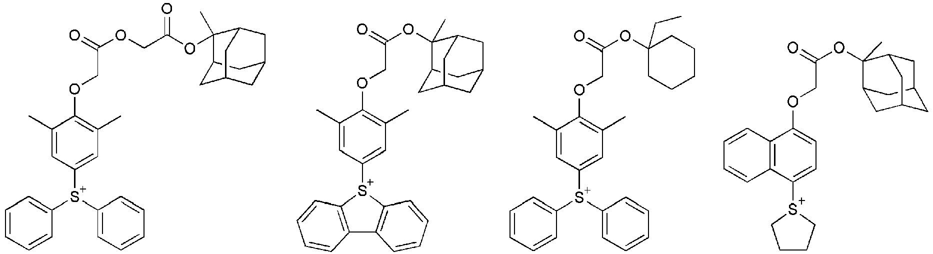

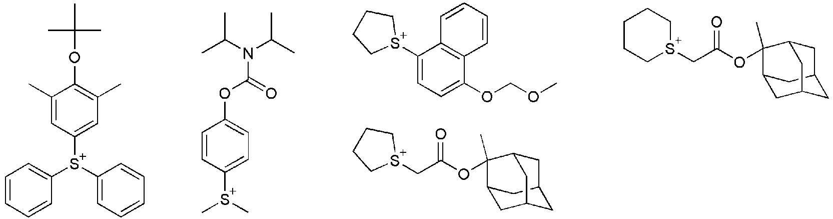

### [1-1-2-1-2. Organic Sulfonium Dication Having One or More Polar Groups Each Having Acid-Dissociable Group]

The organic sulfonium dication having one or more polar groups each having an acid-dissocia ble group is not particularly limited and may be a known and commonly used one. The organic sulfoni um dication having one or more polar groups each having an acid-dissociable group is, for example, an organic sulfonium dication represented by the following general formula (VII-2).

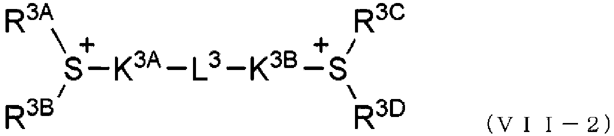

In the general formula (VII-2),
R^{3A}, R^{3B}, R^{3C}, and R^{3D} each independently denote a C₁₋₁₈ hydrocarbyl group, a 3- to 18-membered non-aromatic heterocyclic group, or a 5- to 18-membered aromatic heterocyclic group, each optionally having a substituent,
a divalent carbon atom at any position of R^{3A}, R^{3B} R^{3C}, and R^{3D} excluding the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time),
K^{3A}, K^{3B} and L³ each independently represent a C₁₋₁₈ hydrocarbylene group optionally having a substituent,
a divalent carbon atom at any position of K^{3A}, K^{3B} and L³ may be substituted with -O-, -C(=O)-, - C(=O)O-, -OCO-, -CONH-, -NHCO-, -S-, or -SO₂- (provided that adjacent divalent carbon atoms are not substituted at the same time); and
a hydrogen atom in R^{3A}, R^{3B}, R^{3C}, R^{3D}, K^{3A}, K^{3B}, and L³ may be substituted with (a) a halog en atom, (b) a haloalkyl group, (c) a hydroxy group, (d) a thiol group, (e) a nitro group, (f) a cyano gr oup, (g) a carboxy group, (h) an amino group, (i) a sulfo group, (j) a vinyl group, (k) an allyl group, ( l) a (meth)acryloyl group, (m) a (meth)acryloyloxy group, (n) a (meth)acrylamide group, (o) a styryl gro up, (p) an epoxy group, (q) a glycidyl group, (r) an amide group, (s) a hydroxy or carboxy group havin g a protective group, (t) a polar group having an acid-dissociable group, or (u) a C₁₋₁₈ hydrocarbyl grou p, a C₁₋₁₈ hydrocarbyloxy group, a C₁₋₁₈ hydrocarbylcarbonyl group, a C₁₋₁₈ hydrocarbylcarbonyloxy group , a C₁₋₁₈ hydrocarbyloxycarbonyl group, a C₁₋₁₈ hydrocarbyloxycarbonyloxy group, or a C₁₋₁₈ hydrocarbylt hio group, in which at least a part of the hydrogen atoms may be substituted with (a) to (t), wherein a divalent carbon atom at any position excluding the terminal positions of these substituents may be substit uted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
furthermore, at least one hydrogen atom in R^{3A}, R^{3B}, R^{3C}, R^{3D}, K^{3A}, K^{3B}, and L³ is substitute d with the (t) polar group having an acid-dissociable group; and
any two of R^{3A}, R^{3B}, and K^{3A} and/or any two of R^{3C}, R^{3D}, and K^{3B} may be bonded to each other directly by a single bond or via a divalent linking group -O-, -S-, -C(=O)-, -S(=O)-, -S(=O)₂-, -C( =O)O-, or a C₁₋₃ alkylene group to form a ring together with a sulfur atom in the formula (VII-2).

R^{3A} to R^{3D} are each independently preferably a C₁₋₁₈ hydrocarbyl group optionally having a substituent; in which a divalent carbon atom at any position of R^{3A} to R^{3D} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and a hydrogen atom contained in R^{3A} and R^{3B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{3A} to R^{3D} except the terminal positions may be substituted with -O-, -C(=O)-, -C(=O)O-, -OCO-, -CONH-, -NHCO-, -NH(C=O)O-, - S-, or -SO₂- (provided that adjacent divalent carbon atoms are not substituted at the same time); and a hydrogen atom contained in R^{3A} to R^{3D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time).

K^{3A}, K^{3B}, and L³ preferably each independently denote a C₁₋₁₈ alkylene group or a C₁₋₁₈ aryle ne group, each optionally having a substituent;
a divalent carbon atom at any position of K^{3A}, K^{3B}, and L³ may be substituted with -O-, -C( =O)-, -C(=O)O-, -OCO-, -CONH-, -NHCO-, -S-, or -SO₂- (provided that adjacent divalent carbon atoms are not substituted at the same time);
a hydrogen atom in K^{3A}, K^{3B}, and L³ may be substituted with (a) a halogen atom, (b) a halo alkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy gr oup, (q) a glycidyl group, (r) an amide group, (s) a hydroxy or carboxy group having a protective grou p, or (t) a polar group having an acid-dissociable group.

R^{3A}, R^{3B}, R^{3C}, R^{3D}, K^{3A}, K^{3B}, and/or L³, each having one or more polar groups each having a n acid-dissociable group, are, for example, one into which a polar group having an acid-dissociable grou p, such as a hydroxy group, a carboxy group, an amino group, or a sulfo group, each having an acid-di ssociable group, is introduced. The acid-dissociable group is, for example, a tertiary-carbon-type acid-dis sociable group G_{A}, an allyl- or benzyl-type acid-dissociable group G_{B}, an acetal-type acid-dissociable gro up G_{C}, an aminocarbonyl-type acid-dissociable group G_{D}, or the like.

R^{3A} to R^{3D}, each having one or more polar groups each having an acid-dissociable group, are, for example, those exemplified above as R^{2A} having one or more polar groups each having an acid-diss ociable group.

### [1-1-2-1-3. Organic Iodonium Cation Having One or More Polar Groups Each Having Acid-Dissociable Group]

The organic iodonium cation having one or more polar groups each having an acid-dissociable group is not particularly limited and may be a known and commonly used one. The organic iodonium cation having one or more polar groups each having an acid-dissociable group is, for example, an organi c iodonium cation represented by the following general formula (VII-3).

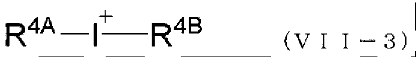

In general formula (VII-3), R^{4A} and R^{4B} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{4A} and R^{4B} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
a hydrogen atom in R^{4A} and R^{4B} may be substituted with (a) a halogen atom, (b) a haloalkyl group, (c) a hydroxy group, (d) a thiol group, (e) a nitro group, (f) a cyano group, (g) a carboxy group , (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, ( q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxyca rbonyl group, or a C₁₋₁₈ hydrocarbyloxycarbonyloxy group, in which at least a part of the hydrogen atom s may be substituted with (a) to (t), wherein a divalent carbon atom at any position excluding the termi nal positions of these substituents may be substituted with -O-, -C(=O)-, -C(=O)O-, -OCO-, -CONH-, -N HCO-, -NH(C=O)O-, -S-, or -SO₂- (provided that adjacent divalent carbon atoms are not substituted at th e same time);
one or more hydrogen atoms in R^{4A} are substituted with the (t) polar group having an acid-di ssociable group, and
R^{4A} and R^{4B} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with an iodine atom in the formula (VII-3).

R^{4A} having one or more polar groups each having an acid-dissociable group preferably denotes
a C₁₋₁₈ hydrocarbyl group optionally having a substituent; in which a divalent carbon atom at any position of R^{4A} except the terminal positions may be substituted with -O-, -C(=O)-, -C(=O)O-, -OC O-, -CONH-, -NHCO-, -NH(C=O)O-, -S-, or -SO₂- (provided that adjacent divalent carbon atoms are not substituted at the same time); one in which at least one hydrogen atom in R^{4A} is substituted with the (t) polar group having an acid-dissociable group,
more preferably a C₁₋₁₈ alkyl group, a C₃₋₁₈ alicyclic group, a C₆₋₁₈ aryl group, or a C₇₋₁₈ aral kyl group, each optionally having a substituent; in which a divalent carbon atom at any position of R^{4A} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the sa me time); one in which at least one hydrogen atom in R^{4A} is substituted with the (t) polar group having an acid-dissociable group,
still more preferably a C₆₋₁₈ aryl group or a C₇₋₁₈ aralkyl group, each optionally having a subs tituent; in which a divalent carbon atom at any position of R^{4A} except the terminal positions may be su bstituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); one in which at least one hydr ogen atom in R^{4A} is substituted with the (t) polar group having an acid-dissociable group.

R^{4A} is characterized by having one or more polar groups each having an acid-dissociable grou p; for example, it incorporates a polar group, such as a hydroxy group, a carboxy group, an amino grou p, or a sulfo group, each having an acid-dissociable group. The acid-dissociable group is, for example, a tertiary-carbon-type acid-dissociable group G_{A}, an allyl- or benzyl-type acid-dissociable group G_{B}, an ac etal-type acid-dissociable group G_{C}, an aminocarbonyl-type acid-dissociable group G_{D}, or the like.

R^{4A} having one or more polar groups each having an acid-dissociable group is, for example, o ne exemplified above as R^{2A} having one or more polar groups each having an acid-dissociable group.

R^{4B} is preferably a C₁₋₁₈ hydrocarbyl group optionally having a substituent; in which a divalent carbon atom at any position of R^{4B} except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time); and a hydrogen atom contained in R^{4B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{4B} except the terminal positions may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time); and a hydrogen atom contained in R^{4B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time).

### [1-1-2-2. Other Counter Cations (A^{m+})]

Other counter cations (A^{m+}) according to the present embodiment include H⁺, a metal ion, an ammonium cation, an ammonium dication, a phosphonium cation, and a phosphonium dication.

### <Metal Ion>

A metal ion that can be used as "A^{m+}" is not particularly limited but is, for example, Li⁺, Na ⁺, K⁺, Rb⁺, Cs⁺, Be²⁺, Mg²⁺, Ca²⁺, Sr²⁺, Ba²⁺, Al³⁺, Co³⁺, Bi³⁺, Zr⁴⁺, Hf⁴⁺, Bi⁵⁺, or the like. These meta 1 ions may be used alone or in combination of two or more thereof.

The metal ion is preferably Li⁺, Na⁺, K⁺, Rb⁺, Cs⁺, Mg²⁺, Ca²⁺, Sr²⁺, Ba²⁺, Al³⁺, or Co³⁺, more preferably Na⁺, K⁺, Rb⁺, Cs⁺, Ca²⁺, Al³⁺, or Co³⁺.

### <Ammonium Cation>

The ammonium cation is not particularly limited and may be a known and commonly used on e. The ammonium cation is not particularly limited but is, for example, an ammonium ion (NH₄⁺), a pr imary ammonium cation (NH₃(R^{5A})⁺), a secondary ammonium cation (NH₂(R^{5A})(R^{5B})⁺), a tertiary ammoni um cation (NH(R^{5A})(R^{5B})(R^{5C})⁺), or a quaternary ammonium cation (N(R^{5A})(R^{5B})(R^{5C})(R^{5D})⁺). R^{5A} to R^{5D} denote the same as defined below.

The ammonium cation is preferably an ammonium ion (NH₄⁺) or a quaternary ammonium cation; particularly, an ammonium ion (NH₄⁺) or an organic quaternary ammonium cation represented by the following general formula (VIII-1) is more preferred.

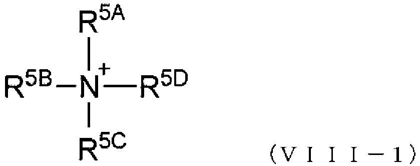

In general formula (VIII-1), R^{5A} to R^{5D} each independently represent a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R^{5A} to R^{5D} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
a hydrogen atom in R^{5A} to R^{5D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); and
any two of R^{5A} to R^{5D} may be bonded to each other directly by a single bond or via a divalent linking group -O-, -S-, -C(=O)-, -S(=O)-, -S(=O)₂-, -C(=O)O-, or a C1-3 alkylene group to form a ring together with a nitrogen atom in the formula (VIII-1).

In the general formula (VIII-1), R^{5A} to R^{5D} preferably each independently denote a C₁₋₁₈ hydro carbyl group optionally having a substituent, more preferably a C₁₋₁₂ alkyl group, a C₁₋₁₂ alkenyl group, a C₁₋₁₂ alkynyl group, or a C₁₋₁₂ alicyclic group.

Specific examples of the organic quaternary ammonium cation include a tetramethylammonium cation, a tetraethylammonium cation, a tetrapropylammonium cation, a tetrabutylammonium cation, a tetra heptylammonium cation, a trimethylethylammonium cation, a dimethyldiethylammonium cation, a dimethyl ethylpropylammonium cation, a methylethylpropylbutylammonium cation, a trimethylphenylammonium catio n, a triethylhexylammonium cation, a triethylcyclohexylammonium cation, a dodecyltrimethylammonium ca tion, and the like.

### <Ammonium Dication>

The ammonium dication is not particularly limited and may be a known and commonly used one. The ammonium dication is, for example, an organic quaternary ammonium dication represented by the following general formula (VIII-2).

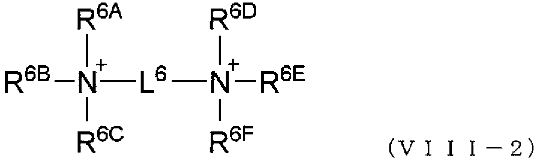

In general formula (VIII-2), R^{6A} to R^{6F} each independently denote a hydro group, an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{6A} to R^{6F} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
L⁶ denotes an optionally substituted C₁₋₁₈ hydrocarbylene group;
the above L⁶ may be substituted with -O-, -C(=O)-, -C(=O)O-, -OCO-, -CONH-, -NHCO-, -S-, or - SO₂- (provided that adjacent divalent carbon atoms are not substituted at the same time);
a hydrogen atom in R^{6A} to R^{6F} and L⁶ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); and
furthermore, any two of R^{6A} to R^{6F} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a nitrogen atom in the formula (VIII-2).

The organic quaternary ammonium dication represented by the general formula (VIII-2) is not particularly limited but is, for example, 1,4-diallyl-1,4-diazabicyclo[2.2.2]octane-1,4-diium, 1,4-di(2-(meth)acryloyloxyethyl)-1,4-diazabicyclo[2.2.2]octane-1,4-diium, 1,4-bis(2-(meth)acrylamidoethyl)-1,4-diazabicyclo[2.2.2]octane-1,4-diium, or the like.

### <Phosphonium Cation>

The phosphonium cation is not particularly limited and may be a known and commonly used one. The phosphonium cation is, for example, an organic quaternary phosphonium cation represented by the following general formula (VIII-3).

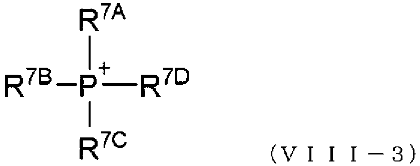

In general formula (VIII-3), R^{7A} to R^{7D} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{7A} to R^{7D} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
a hydrogen atom in R^{7A} to R^{7D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); and
any two of R^{7A} to R^{7D} may be bonded to each other directly by a single bond or via a dival ent linking group -O-, -S-, -C(=O)-, -S(=O)-, -S(=O)₂-, -C(=O)O-, or a C₁₋₃ alkylene group to form a rin g together with a phosphorus atom in the formula (VIII-3).

R^{7A}, R^{7B}, R^{7C}, and R^{7D} in the formula (VIII-3) preferably each independently denote a C₁₋₁₈ h ydrocarbyl group optionally having a substituent, more preferably a C₁₋₁₂ alkyl group, a C₁₋₁₂ alkenyl gro up, a C₁₋₁₂ alkynyl group, or a C₁₋₁₂ alicyclic group.

Specific examples of the organic phosphonium cation include a (methoxymethyl)triphenylphosph onium cation, a tetrabutylphosphonium cation, a tetraethylphosphonium cation, an amyltriphenylphosphoniu m cation, an acetonyltriphenylphosphonium cation, a benzyltriphenylphosphonium cation, an ethyltriphenyl phosphonium cation, a butyltriphenylphosphonium cation, a hexyltriphenylphosphonium cation, a (1-naphth ylmethyl)triphenylphosphonium cation, a (4-nitrobenzyl)triphenylphosphonium cation, a (2-hydroxybenzyl)tri phenylphosphonium cation, a tetraphenylphosphonium cation, a triphenyltetradecylphosphonium cation, a c yclopropylphenylphosphonium cation, an ethoxycarbonylmethyl(triphenyl)phosphonium cation, a phenacyltri phenylphosphonium cation, and the like.

### <Phosphonium Dication>

The phosphonium dication is not particularly limited and may be a known and commonly use d one. The phosphonium dication is, for example, an organic quaternary phosphonium dication represent ed by the following general formula (VIII-4).

In general formula (VIII-4), R^{8A} to R^{8F} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{8A} to R^{8F} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
L⁸ represents a C₁₋₁₈ hydrocarbylene group optionally having a substituent,
a divalent carbon atom at any position of L⁸ may be substituted with -O-, -C(=O)-, -C(=O)O-, -OCO-, -CONH-, -NHCO-, -S-, or -SO₂- (provided that adjacent divalent carbon atoms are not substituted at the same time);
a hydrogen atom in R^{8A} to R^{8F} and L⁸ may be substituted with (a) a halogen atom, (b) a hal oalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy gr oup, (q) a glycidyl group, (r) an amide group, (s) a hydroxy or carboxy group having a protective grou p, (t) a polar group having an acid-dissociable group, or (u) a C₁₋₁₈ hydrocarbyl group, a C₁₋₁₈ hydrocarb yloxy group, a C₁₋₁₈ hydrocarbylcarbonyl group, a C₁₋₁₈ hydrocarbylcarbonyloxy group, a C₁₋₁₈ hydrocarby loxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl gro up, a C₁₋₁₈ hydrocarbylcarbonylamino group, a C₁₋₁₈ hydrocarbylaminocarbonyloxy group, a di-C₁₋₁₈ hydro carbylaminocarbonyloxy group, a C₁₋₁₈ hydrocarbylaminocarbonylamino group, a di-C₁₋₁₈ hydrocarbylamino carbonylamino group, a C₁₋₁₈ hydrocarbyloxycarbonylamino group, or a C₁₋₁₈ hydrocarbylthio group, in w hich at least a part of the hydrogen atoms may be substituted with (a) to (t), wherein a divalent carbon atom at any position excluding the terminal positions of these substituents may be substituted with -O-, - C(=O)-, -C(=O)O-, -OCO-, -CONH-, -NHCO-, -NH(C=O)O-, -S-, or -SO₂- (provided that adjacent divale nt carbon atoms are not substituted at the same time);
any two of R^{8A} to R^{8F} may be bonded to each other directly by a single bond or via a dival ent linking group -O-, -S-, -C(=O)-, -S(=O)-, -S(=O)₂-, -C(=O)O-, or a C₁₋₃ alkylene group to form a rin g together with a phosphorus atom in the formula (VIII-4).

The organic quaternary phosphonium dication represented by the general formula (VIII-4) is not particularly limited but is, for example, a trans-2-butene-1,4-bis(triphenylphosphonium) dication, an ethylene bis(triphenylphosphonium) dication, a pentamethylene bis(triphenylphosphonium) dication, or the like.

### [1-1-2-3. Ratio of A^{m+} to Bⁿ⁺]

In the general formula (I), m denotes an integer in the range of 1 to 5, n denotes an integer of 1 or 2, a denotes a real number, and b denotes a real number greater than 0.

(A^{m+})ₐ(Bⁿ⁺)_{b}(C^{(am+bn)-}) (I)

Furthermore, a mixture of heteropolyacid salts having a modified lacunary site may contain a plurality of heteropolyacid salts having a modified lacunary site in which the ratio of A^{m+} to Bⁿ⁺ is diff erent. In this case, the values of a and b can be determined by, for example, NMR analysis, XRF anal ysis, XPS analysis, or the like.

The ratio of a to b depends on the types of the heteropolyacid anions having a modified lacu nary site, A^{m+}, and Bⁿ⁺, and is preferably a:b = 0 to 8:1 to 12, more preferably 0 to 4:2 to 8, still mor e preferably 0 to 2:1 to 4.

In particular, when the value of am + bn is an integer in the range of 2 to 8 and m and n are 1, it is preferable that a is a real number in the range of 0 to 7 and b is a real number in the ran ge of 1 to 8, and it is more preferable that a is a real number in the range of 0 to 4 and b is a real number in the range of 2 to 8.

### [1-1-3. Component (A) Content]

The component (A) content of the resist material is not particularly limited and may be appropriately determined according to the method for applying the resist material to a substrate or the like, the thickness of the film to be applied, and the like. The component (A) content of the resist material preferably ranges from 0.01% to 20% by mass, more preferably 0.1% to 15% by mass, still more preferably 0.2% to 10% by mass, relative to 100% by mass of the resist material.

### [1-2. (B) Acid Diffusion Control Agent]

The resist material according to the present embodiment may further contain, as an optional c omponent, (B) an acid diffusion control agent for trapping an acid generated upon exposure, in addition to (A) the heteropolyacid salt having a modified lacunary site or the mixture thereof.

The acid diffusion control agent is not particularly limited, and a known and commonly used acid diffusion control agent can be used. Examples of the acid diffusion control agent include (B1) a photodegradable base that is decomposed by exposure and loses acid diffusion controllability, and (B2) a nitrogen-containing organic compound that does not correspond to the component (B1), and these may be used alone or in combination of two or more thereof.

### [1-2-1. (B1) Photodegradable Base]

The (B1) photodegradable base loses acid diffusion controllability by being decomposed by exposure, while acting as a quencher in a non-exposed portion, thereby making it possible to control diffusion of an acid. Therefore, characteristics such as higher sensitivity, reduction of roughness, and suppression of occurrence of coating defects can be improved by incorporating the (B1) photodegradable base into the resist material.

The photodegradable base is not particularly limited and may be a known and commonly used one. The photodegradable base is, for example, a "carboxylate compound B_{A}" represented by the follo wing general formula (IX-1), a "sulfonate compound B_{B}" represented by the following general formula (I X-2), a "sulfonyl amide salt compound B_{C}" represented by the following general formula (IX-3), or the 1 ike. In the following, a carboxylate anion, a sulfonate anion, a sulfonyl amide anion, and an onium cati on or dication (D^{p+}) in the following general formulae (IX-1) to (IX-3) will be described.

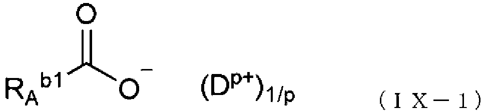

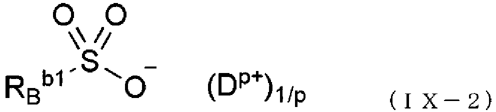

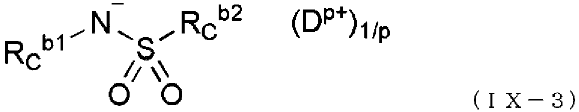

### [1-2-1-1. Carboxylate Compound B_{A}]

The (B1) photodegradable base can be a salt of a carboxylate anion and an onium cation or dication (D^{p+}), such as the "carboxylate compound B_{A}" represented by the following general formula (IX-1).

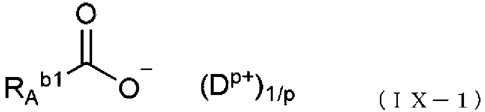

"R_{A}^{b1}" denotes an optionally substituted C₁₋₁₈ hydrocarbyl group, 3- to 18-membered non-aromatic heterocyclic group, or 5- to 18-membered aromatic heterocyclic group in which any divalent carbon atom except the terminal positions may be replaced by -O-, -C(=O)-, -C(=O)O-, -OCO-, -CONH-, -NHCO-, -S-, or -SO₂-(provided that adjacent divalent carbon atoms are not replaced at the same time).

Preferably, R_{A}^{b1} denotes a C₁₋₁₈ hydrocarbyl group optionally having a substituent, and any divalent carbon atom except the terminal positions may be substituted with -O-, -C(=O)-, -C(=O)O-, -OCO-, -CONH-, - NHCO-, -S-, or -SO₂- (provided that adjacent divalent carbon atoms are not substituted at the same time),
more preferably a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

### <Carboxylate Compound B_{A1}>

The carboxylate compound B_{A} represented by the general formula (IX-1) may be a carboxylat e compound B_{A1} represented by the following general formula (IX-1-1).

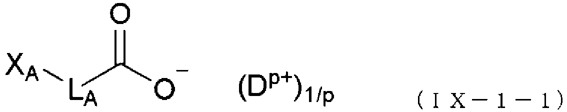

"X_{A}" is a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminals may be substituted with -O-, - C(=O)-, -C(=O)O-, -OCO-, -CONH-, -NHCO-, -S-, or -SO₂- (provided that adjacent divalent carbon atoms are not substituted at the same time).

X_{A} preferably denotes a C₃₋₁₈ alicyclic group, a C₆₋₁₈ aryl group, or a C₇₋₁₈ aralkyl group each optionally having a substituent and any divalent carbon atom except the terminal positions may be replaced by - O-, -C(=O)-, -C(=O)O-, -OCO-, -CONH-, -NHCO-, -S-, or -SO₂- (provided that adjacent divalent carbon atoms are not replaced at the same time),
more preferably a C₃₋₁₈ alicyclic group or a C₆₋₁₈ aryl group each optionally having a substituent and any divalent carbon atom except the terminal positions may be replaced by -O-, -C(=O)-, -C(=O)O-, -OCO-, - CONH-, -NHCO-, -S-, or -SO₂- (provided that adjacent divalent carbon atoms are not replaced at the same time).

"L_{A}" denotes a group that binds X_{A} and -COO⁻ and may be a linking group represented by any one of the following general formulae (L_{A}-1) to (L_{A}-7). 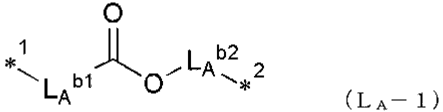 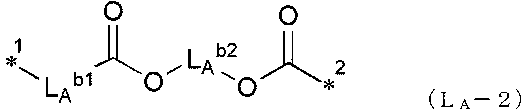 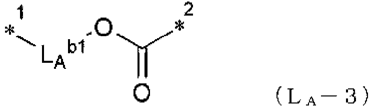 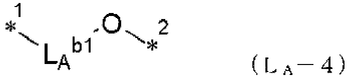 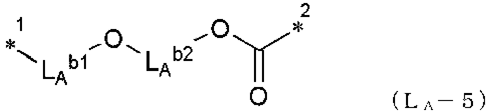 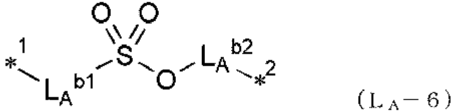 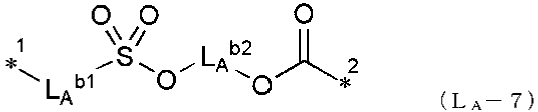 [In the formulae, L_{A}^{b1} and L_{A}^{b2} denote a single bond or a C₁₋₈ hydrocarbylene group optionally having a substituent, *1 denotes a linking portion to X_{A}, and *2 denotes a linking portion to -COO⁻.]

L_{A}^{b1} and L_{A}^{b2} are preferably a single bond, or a C₁₋₈ alkylene group or a C₆₋₈ arylene group each optionally having a substituent, and more preferably a single bond or a C₁₋₈ alkylene group optionally having a substituent.

### <Examples of Carboxylate Anion>

The carboxylate anion of the above-mentioned carboxylate compound B_{A} or B_{A1} is, for example, but not limited to, a trifluoroacetate anion, a pentafluoropropionate anion, a 2-methoxyacetate anion, a 2-methoxy-2-methylpropionate anion, a 2-hydroxyacetate anion, a 2-hydroxy-2-methylpropionate anion, a 2-acetoxyacetate anion, an adamantane-1-carboxylate anion, a 9,10-dihydro-9,10-ethanoanthracene-11-carboxylate anion, a 9,10-dihydro-9,10-[1,2]benzenoanthracene-9-carboxylate anion, a benzoate anion, a salicylate anion, a 3-hydroxybenzoate anion, a 3-trifluoromethylbenzoate anion, or the like.

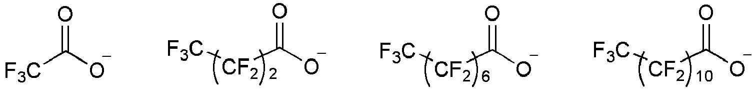

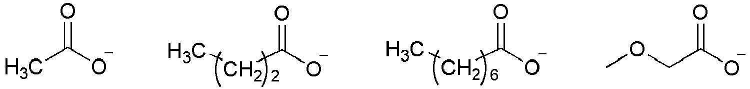

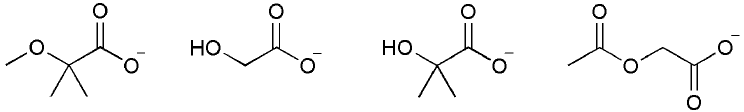

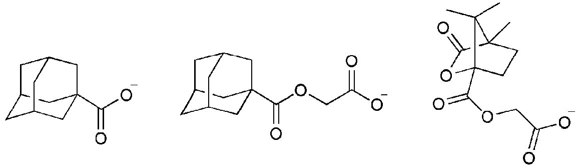

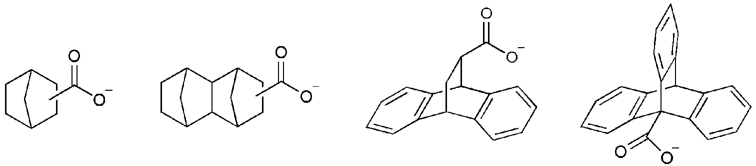

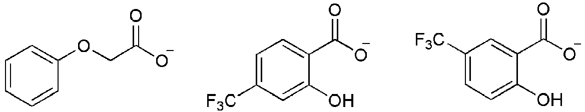

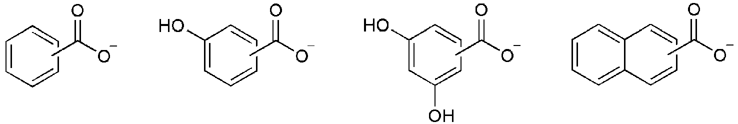

### [1-2-1-2. Sulfonate Compound B_{B}]

The (B1) photodegradable base can be a salt of a sulfonate anion and an onium cation or dic ation (D^{p+}), such as the "sulfonate compound B_{B}" represented by the following general formula (IX-2).

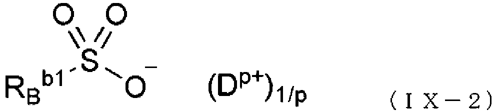

"R_{B}^{b1}" denotes an optionally substituted C₁₋₁₈ hydrocarbyl group, 3- to 18-membered non-aromatic heterocyclic group, or 5- to 18-membered aromatic heterocyclic group in which any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not replaced at the same time).

Preferably, R_{B}^{b1} denotes a C₁₋₁₈ hydrocarbyl group optionally having a substituent, and any divalent carbon atom except the terminal positions may be substituted with -O-, -C(=O)-, -C(=O)O-, -OCO-, -CONH-, - NHCO-, -S-, or -SO₂- (provided that adjacent divalent carbon atoms are not substituted at the same time),
more preferably a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

### <Sulfonate Compound B_{B1}>

The sulfonate compound B_{B} represented by the general formula (IX-2) may be a sulfonate co mpound B_{B1} represented by the following general formula (IX-2-1).

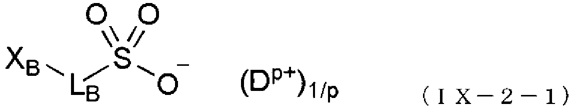

"X_{B}" is a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminals may be substituted with -O-, - C(=O)-, -C(=O)O-, -OCO-, -CONH-, -NHCO-, -S-, or -SO₂- (provided that adjacent divalent carbon atoms are not substituted at the same time).

X_{B} preferably denotes a C₃₋₁₈ alicyclic group, a C₆₋₁₈ aryl group, or a C₇₋₁₈ aralkyl group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time),
more preferably a C₃₋₁₈ alicyclic group or a C₆₋₁₈ aryl group each optionally having a substituent and any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

"L_{B}" denotes a group that binds X_{B} and -SO₂-O⁻ and may be a linking group represented by any one of the following general formulae (L_{B}-1) to (L_{B}-7). 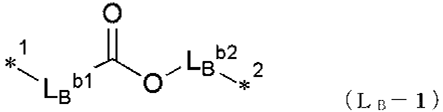 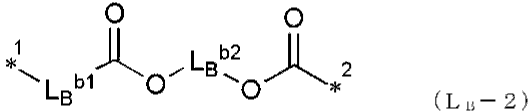 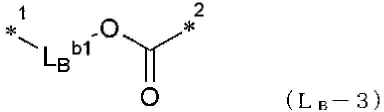 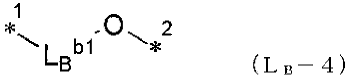 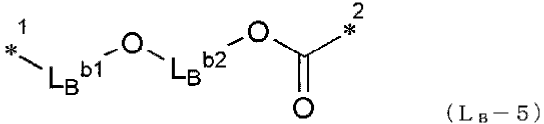 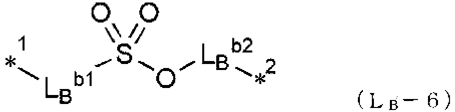 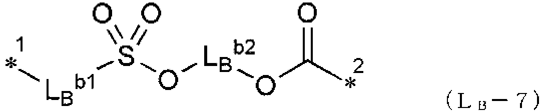 [In the formulae, L_{B}^{b1} and L_{B}^{b2} represent a single bond or a C₁₋₈ hydrocarbylene group optionally having a substituent, *1 represents a linking site to X_{B}, and *2 represents a linking site to -SO₂-O⁻.]

L_{B}^{b1} and L_{B}^{b2} are preferably a single bond, or a C₁₋₈ alkylene group or a C₆₋₈ arylene group each optionally having a substituent, and more preferably a single bond or a C₁₋₈ alkylene group optionally having a substituent.

### <Example of Sulfonate Anion>

The sulfonate anion of the above-mentioned sulfonate compound B_{B} or B_{B1} is, for example, but not limited to, a camphorsulfonate anion, an (adamantan-1-yl)methanesulfonate anion, an (adamantane-1-carbonyloxy)ethane-1-sulfonate anion, a cyclohexane sulfonate anion, a 2-(cyclohexanecarbonyloxy)ethane-1-sulfonate anion, a bicyclo[2.2.1]heptane-2-sulfonate anion, a benzenesulfonate anion, a 4-methylbenzenesulfonate anion, or the like.

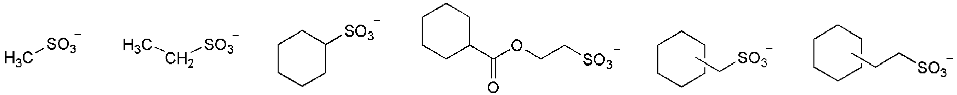

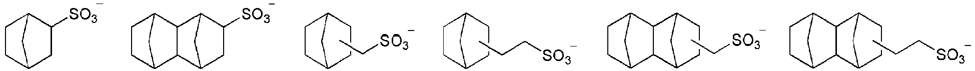

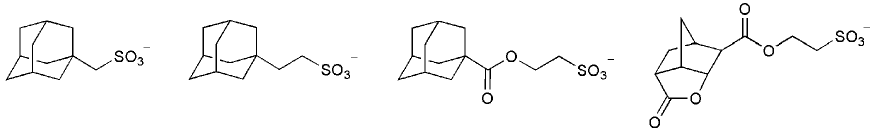

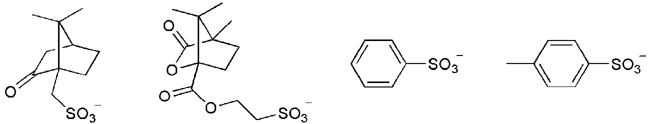

### [1-2-1-3. Sulfonyl Amide Salt Compound B_{C}]

The (B1) photodegradable base can be a salt of a sulfonyl amide anion and an onium cation or dication (D^{p+}), such as the "sulfonyl amide salt compound B_{C}" represented by the following general f ormula (IX-3).

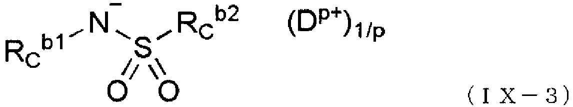

"R_{C}^{b1}" denotes an optionally substituted C₁₋₁₈ hydrocarbyl group, 3- to 18-membered non-aromatic heterocyclic group, or 5- to 18-membered aromatic heterocyclic group in which any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not replaced at the same time).

"R_{C}^{b2}" denotes an optionally substituted C₁₋₁₈ hydrocarbyl group, and any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time).

Preferably, R_{C}^{b1} denotes a C₁₋₁₈ hydrocarbyl group optionally having a substituent, and any divalent carbon atom except the terminal positions may be substituted with -O-, -C(=O)-, -C(=O)O-, -OCO-, -CONH-, - NHCO-, -S-, or -SO₂- (provided that adjacent divalent carbon atoms are not substituted at the same time),
more preferably a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

R_{C}^{b2} denotes a C₁₋₁₈ alkyl group or a C₃₋₁₈ alicyclic group, each optionally having a substituen t, wherein any divalent carbon atom excluding the terminals may be substituted with -O-, -C(=O)-, -C(= O)O-, -OCO-, -CONH-, -NHCO-, -S-, or -SO₂- (provided that adjacent divalent carbon atoms are not su bstituted at the same time).

It is preferably a C₁₋₁₂ haloalkyl group, more preferably a C₁₋₅ fluorinated alkyl group.

### <Sulfonyl Amide Salt Compound B_{C1}>

The sulfonyl amide salt compound B_{C} represented by the general formula (IX-3) may be a sul fonyl amide salt compound B_{C1} represented by the following general formula (IX-3-1).

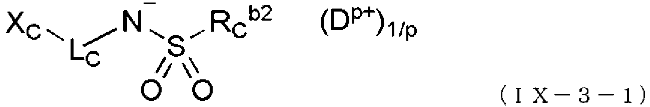

"X_{C}" is a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminals may be substituted with -O-, - C(=O)-, -C(=O)O-, -OCO-, -CONH-, -NHCO-, -S-, or -SO₂- (provided that adjacent divalent carbon atoms are not substituted at the same time).

X_{C} preferably denotes a C₃₋₁₈ alicyclic group, a C₆₋₁₈ aryl group, or a C₇₋₁₈ aralkyl group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time),
more preferably a C₃₋₁₈ alicyclic group or a C₆₋₁₈ aryl group each optionally having a substituent and any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

"L_{C}" denotes a group that binds X_{C} and -N⁻-SO₂-R_{C}^{b2} and may be a linking group represented by any one of the following general formulae (L_{C}-1) to (L_{C}-7). 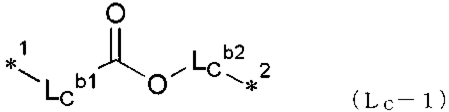 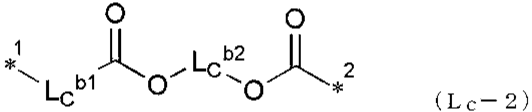 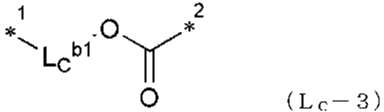 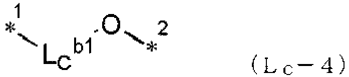 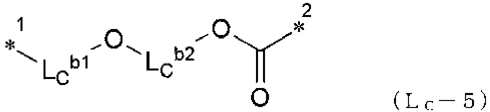 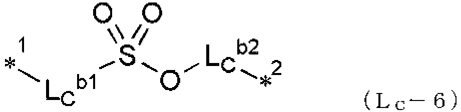 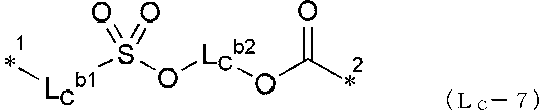 [In the formula, L_{C}^{b1} and L_{C}^{b2} represent a single bond or a C₁₋₁₂ hydrocarbylene group optionally having a substituent, *1 represents a linking site to X_{C}, and *2 represents a linking site to -N⁻-SO₂-R_{C}^{b2}.]

L_{C}^{b1} and L_{C}^{b2} are preferably a single bond, or a C₁₋₁₂ alkylene group, a C₁₋₁₂ cycloalkylene group, or a C₆₋₁₂ arylene group, each optionally having a substituent, and more preferably a single bond or a C₁₋₈ alkylene group or a C₁₋₈ cycloalkylene group each optionally having a substituent.

### <Examples of Sulfonylamide Anion>

Examples of the sulfonylamide anion of the sulfonylamide salt compound B_{C} or B_{C1} include, but are not particularly limited to, a methyl((trifluoromethyl)sulfonyl)amide anion, an i-propyl((trifluoromethyl)sulfonyl)amide anion, a methacryloyloxy((trifluoromethyl)sulfonyl)amide anion, a 2-(methacryloyloxy)ethyl((trifluoromethyl)sulfonyl)amide anion, a cyclohexyl((trifluoromethyl)sulfonyl)amide anion, a 2-((cyclopentanecarbonyl)oxy)ethyl((trifluoromethyl)sulfonyl)amide anion, a 2-((cyclohexanecarbonyl)oxy)ethyl((trifluoromethyl)sulfonyl)amide anion, a bicyclo[2.2.1]heptan-2-ylmethyl((trifluoromethyl)sulfonyl)amide anion, a bicyclo[2.2.1]heptan-7-ylmethyl((trifluoromethyl)sulfonyl)amide anion, a 2-((adamantan-1-carbonyl)oxy)ethyl((trifluoromethyl)sulfonyl)amide anion, a 2-(adamantan-1-carboxamido)ethyl((trifluoromethyl)sulfonyl)amide anion, a 2-(4-((adamantan-1-carbonyl)oxy)cyclohexyl)ethyl((trifluoromethyl)sulfonyl)amide anion, and a 4-((adamantan-1-carbonyl)oxy)phenyl((trifluoromethyl)sulfonyl)amide anion and the like.

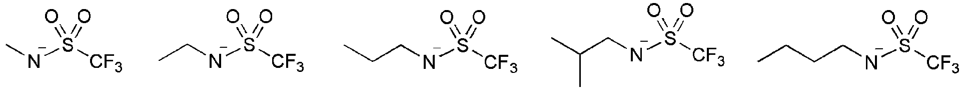

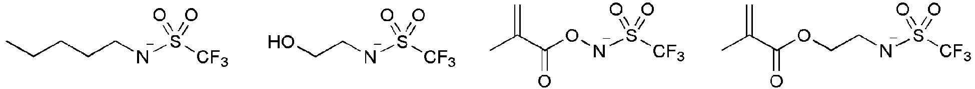

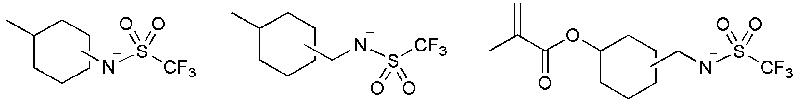

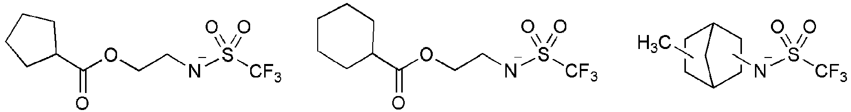

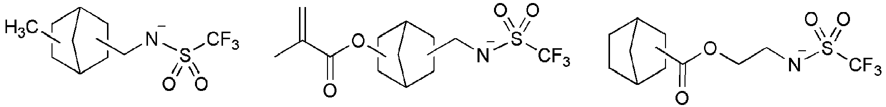

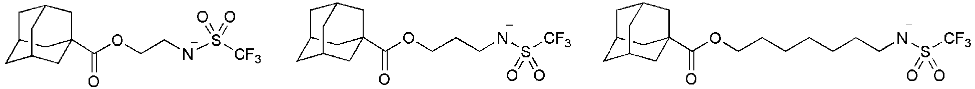

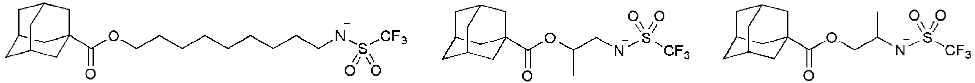

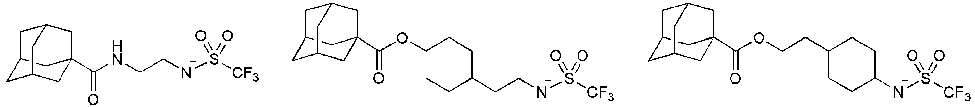

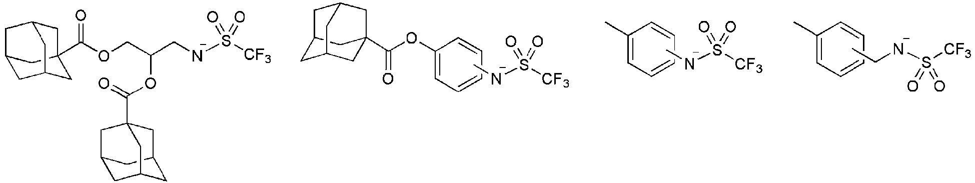

### [1-2-1-4. Onium Cation or Dication (D^{p+})]

The (B1) photodegradable base can have an onium cation or dication D^{p+} as a cation moiety. In "(D^{p+})_{1/p}" represented by the general formulae (IX-1) to (IX-3), (D^{p+}) denotes an onium cation or dic ation, and p denotes an integer of 1 or 2.

The onium cation or dication is not particularly limited and may be an organic sulfonium cati on, an organic sulfonium dication, an organic iodonium cation, an organic quaternary ammonium cation, an organic quaternary ammonium dication, an organic phosphonium cation, an organic phosphonium dicat ion, or the like.

The onium cation or dication (D^{p+}) can be, for example, an organic sulfonium cation represent ed by the following general formula (X-1).

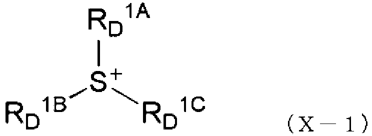

In general formula (X-1), R_{D}^{1A}, R_{D}^{1B}, and R_{D}^{1C} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R_{D}^{1A}, R_{D}^{1B}, and R_{D}^{1C} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
any two of R_{D}^{1A}, R_{D}^{1B}, and R_{D}^{1C} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the formula (X-1).

The onium cation or dication (D^{p+}) can be, for example, an organic sulfonium dication represe nted by the following general formula (X-2).

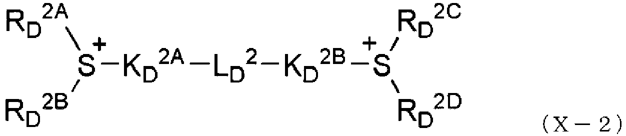

In general formula (X-2), R_{D}^{2A}, R_{D}^{2B}, R_{D}^{2C}, and R_{D}^{2D} each independently represent a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R_{D}^{2A} , R_{D}^{2B}, R_{D}^{2C}, and R_{D}^{2D} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
K_{D}^{2A}, K_{D}^{2B}, and L_{D}² each independently represent a C₁₋₁₈ hydrocarbylene group optionally having a substituent, and
a divalent carbon atom at any position of K_{D}^{2A} , K_{D}^{2B}, and L_{D}² may be substituted with -O-, -C(=O)-, - C(=O)O-, -OCO-, -CONH-, -NHCO-, -S-, or -SO₂- (provided that adjacent divalent carbon atoms are not substituted at the same time); and
any two of R_{D}^{2A}, R_{D}^{2B}, and K_{D}^{2A} and/or any two of R_{D}^{2C}, R_{D}^{2D}, and K_{D}^{2B} may be linked to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in formula (X-2).

The onium cation or dication (D^{p+}) can be, for example, an organic iodonium cation represent ed by the following general formula (X-3).

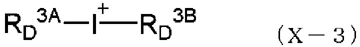

In general formula (X-3), R_{D}^{3A} and R_{D}^{3B} each independently represent a C₁₋₁₈ hydrocarbyl group, a 3-to 18-membered non-aromatic heterocyclic group, or a 5- to 18-membered aromatic heterocyclic group, the hydrocarbyl group and the heterocyclic groups each optionally having a substituent, and
a divalent carbon atom at any position of R_{D}^{3A} and R_{D}^{3B} except the terminal positions may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time);
R_{D}^{3A} and R_{D}^{3B} may be bonded to each other directly by a single bond or via a divalent linking group - O-, -S-, -C(=O)-, -S(=O)-, -S(=O)₂-, -C(=O)O-, or a C₁₋₃ alkylene group to form a ring together with the iodine atom in the formula (X-3).

### [1-2-2. (B2) Nitrogen-containing Organic Compound]

As another (B) acid diffusion control agent, (B2) a nitrogen-containing organic compound that does not correspond to (B1) may be contained. The nitrogen-containing organic compound is not particularly limited, and, for example, an aliphatic amine, an aromatic amine, a heterocyclic amine, or the like can be used.

Examples of the nitrogen-containing organic compound include aliphatic amines such as n-hexylamine, n-heptylamine, diethylamine, di-n-propylamine, di-n-butylamine, triethylamine, tri-n-propylamine, tri-n-butylamine, tri-n-pentylamine, and tri-n-octylamine; aromatic amines such as aniline, N-methylaniline, N-ethylamine, N,N-dimethylaniline, 4-methylaniline, and pyrrole; and heterocyclic amines such as pyridine, imidazole, benzimidazole, piperidine, piperazine, 1,5-diazabicyclo[4.3.0]-5-nonene, 1,8-diazabicyclo[5.4.0]-7-undecene, hexamethylenetetramine, and 1,4-diazabicyclo[2.2.2]octane.

These nitrogen-containing organic compounds may be used alone or in combination of two or more thereof.

### [1-2-3. Blending Amount of the component (B)]

The content of the (B) acid diffusion control agent in the resist material according to the present embodiment is not particularly limited and can be appropriately selected depending on the content, type, and the like of the component (A). The content of the component (B) in the resist material is preferably 0.1 to 30 parts by mass, more preferably 0.2 to 25 parts by mass, and still more preferably 0.5 to 20 parts by mass relative to 100 parts by mass of the component (A).

### [1-3. Organic Solvent]

The resist material according to the present embodiment may further contain an organic solvent. The organic solvent is not particularly limited and may be a known and commonly used one. The organic solvent is preferably an organic solvent that can uniformly dissolve or disperse the (A) heteropolyacid salt having a modified lacunary site or the mixture thereof during preparation.

Examples of the organic solvent include a polar solvent, such as an alcohol solvent, an ether solvent, a ketone solvent, an amide solvent, an ester solvent, a nitrile solvent, or an aprotic polar solvent, and a nonpolar solvent, such as a hydrocarbon solvent. These organic solvents may be used alone or in combination of two or more types thereof.

Specific examples of the polar solvent include an alcohol solvent, such as methanol, ethanol, isopropyl alcohol (IPA), diacetone alcohol (DAA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether; a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
a nitrile solvent, such as acetonitrile, propionitrile, or benzonitrile; and
an aprotic polar solvent, such as γ-butyrolactone, δ-valerolactone, γ-lactam, δ-lactam, dimethyl sulfoxide (DMSO), sulfolane, 1,3-dimethyl-2-imidazolidinone, or tetramethylurea; and
the nonpolar solvent may be a hydrocarbon solvent, such as n-pentane, n-hexane, toluene, or xylene; or the like.

These organic solvents may be used alone or in combination of two or more types thereof.

The organic solvent to be contained in the resist material according to the present embodiment is preferably a polar solvent from the perspective of coatability, more preferably an amide solvent, an ester solvent, an alcohol solvent, or a ketone solvent from the perspective of solubility. The amide solvent is preferably at least one selected from the group consisting of N,N-dimethylformamide, N,N-diethylformamide, acetamide, and N-methylpyrrolidone. Furthermore, from the perspective of solubility, the ester solvent or the alcohol solvent preferably has an ester bond and/or a hydroxy group, and among those described above, at least one selected from the group consisting of propylene glycol monomethyl ether, methyl lactate, ethyl lactate, methyl acetate, ethyl acetate, methyl pyruvate, ethyl pyruvate, and propylene glycol monomethyl ether acetate is preferred.

The organic solvent content of the resist material is not particularly limited and can be appropriately determined according to the method for applying the resist material to a substrate or the like, the thickness of the film to be applied, and the like. The organic solvent content of the resist material is such that the solid concentration of the resist material preferably ranges from 0.01% to 20% by mass, more preferably 0.1% to 15% by mass, still more preferably range of 0.2% to 10% by mass.

### [1-4. Others]

If desired, the resist material according to the present embodiment can appropriately contain, as a miscible additive agent, for example, an additional resin for improving the performance of a resist film, a dissolution inhibitor, a plasticizer, a stabilizer, a colorant, an antihalation agent, a dye, or the like.

The resist material according to the present embodiment preferably does not contain an epoxy resin. Furthermore, hydrogen peroxide is also preferably not contained.

### [2. Pattern Formation Method]

The pattern formation method according to the present embodiment includes a step of applying a resist material to a substrate, a step of exposing a resist film formed by the application step to light, and a step of developing the exposed resist film.

### [2-1. Application Step]

The pattern formation method according to the present embodiment includes the step of applying a resist material to a substrate.

### <Substrate>

The substrate used in the present embodiment is not particularly limited and can be a known and commonly used substrate. The substrate is, for example, a substrate for an electronic component, a substrate on which a predetermined wiring pattern is formed, or the like

The material of the substrate is, for example, but not limited to, a silicon wafer, a substrate made of a metal, such as copper, chromium, iron, or aluminum, a substrate made of an inorganic substance, such as glass, titanium oxide, or silicon dioxide, or the like.

The substrate may have any size, shape, and the like, may have a smooth, curved, or rough surface, and may be a flaky substrate or the like.

The surface of the substrate may be subjected to a surface treatment as necessary. In the case of a substrate having a hydroxy group on a surface layer thereof, the surface of the substrate may be treated with a silane coupling agent capable of reacting with the hydroxy group to change the surface layer of the substrate from hydrophilic to hydrophobic, thereby enhancing the adhesion between the substrate and a film containing a metal compound. The silane coupling agent is, for example, hexamethyldisilazane (HMDS) or the like.

### <Application Method>

The method for applying the resist material to a substrate is not particularly limited and can be a known and commonly used method. The application method includes a dry method, for example, a chemical vapor deposition (CVD) method, such as thermal CVD, plasma CVD, or photo-CVD; a physical vapor deposition (PVD) method, such as vacuum deposition, plasma-assisted vapor deposition, sputtering, or ion plating; or the like. A wet method, for example, a coating method, such as spin coating, bar coating, roll coating, flow coating, dip coating, spray coating, ink jet printing, or screen printing, can also be used.

From the perspective of forming a film with a uniform thickness or the like, the method for applying the resist material according to the present embodiment to a substrate is preferably a wet method, such as a spin coating method or screen printing, more preferably a spin coating method. After the coating film is formed, a backside rinse step, an edge bead removal step, or the like may be performed to remove an edge bead.

A resist film formed by applying the resist material to a substrate may be dried by any method, for example, using a heater (post-apply bake (PAB)), such as a hot plate, or a pressure reduction apparatus.

The baking conditions are not particularly limited and can be appropriately determined according to the type, application, and the like of the resist film. The baking temperature preferably ranges from 80°C to 300°C, more preferably 80°C to 200°C, still more preferably 80°C to 130°C. The baking time preferably ranges from 10 seconds to 300 seconds, more preferably 20 seconds to 180 seconds, still more preferably 30 seconds to 120 seconds.

The thickness of the resist film after drying is preferably, but not limited to, in the range of 0.5 to 100 nm, more preferably 1 to 75 nm, still more preferably 1 to 60 nm.

### [2-2. Exposure Step]

The pattern formation method according to the present embodiment includes a step of exposing the resist film formed by the application step to light.

As an exposure apparatus in the exposure step of the resist film, for example, an ArF exposure apparatus, an electron-beam lithography system, an EUV exposure apparatus, or the like can be used. Furthermore, in the exposure step, exposure may be performed through a mask (mask pattern) on which a predetermined pattern is formed, or selective exposure may be performed by drawing or the like by direct irradiation with an electron beam without using a mask pattern.

The exposure wavelength is not particularly limited, and radiation, such as an ArF excimer laser (wavelength: 193 nm), a KrF excimer laser (248 nm), an F₂ excimer laser (wavelength: 157 nm), extreme ultraviolet (EUV), vacuum ultraviolet (VUV), an electron beam (EB), X-rays, soft X-rays, or the like may be used.

For an ArF excimer laser or a KrF excimer laser, the exposure level on the resist film preferably ranges from 1 to 200 mJ/cm², more preferably 20 to 60 mJ/cm². Furthermore, for extreme ultraviolet, the exposure level is, for example, 500 mJ/cm² or less, preferably 0.1 to 200 mJ/cm², more preferably 3 to 100 mJ/cm², still more preferably 5 to 50 mJ/cm².

For an electron beam, exposure at a dose in the range of 3 µC/cm² to 2 mC/cm² at 50 kV is preferred, and exposure at a dose in the range of 10 µC/cm² to 1.5 mC/cm² is more preferred.

After the resist film is exposed to light, a baking (post-exposure bake (PEB)) treatment may or may not be performed. The baking conditions are not particularly limited and can be appropriately determined according to the type, application, and the like of the resist film. The baking temperature preferably ranges from 80°C to 300°C, more preferably 80°C to 200°C, still more preferably 80°C to 130°C, using a heater, such as a hot plate. The baking time preferably ranges from 10 seconds to 300 seconds, more preferably 20 seconds to 180 seconds, still more preferably 30 seconds to 120 seconds.

### [2-3. Development Step]

The pattern formation method according to the present embodiment includes the step of developing the exposed resist film. In the development step, the exposed resist film can be developed with a developer to form a pattern. A case where the exposed region remains as a pattern after development is a negative patterning process, and a case where the exposed region is removed after development is a positive patterning process. Whether a positive or negative pattern is formed can be appropriately selected depending on the resist material or the developer. Furthermore, the development may be followed by washing with a rinse liquid and drying, and in some cases, further followed by a baking treatment.

As the developer used in the present embodiment, an alkali developer may be used as a developer for an alkali development process, and a developer containing an organic solvent (organic developer) may be used as a developer for an organic solvent development process.

### <Alkali Development Process>

The alkali developer used in the alkali development process is not particularly limited, and a known and commonly used alkali developer can be used. Examples of the alkali developer include aqueous solutions containing one or more of quaternary ammonium salts such as tetramethylammonium hydroxide and (2-hydroxyethyl)trimethylammonium hydroxide; inorganic alkalis such as sodium hydroxide and potassium hydroxide; and alkanolamines such as dimethylethanolamine and triethanolamine.

As the rinse liquid in the alkali development process, pure water can be used.

### <Organic Solvent Development Process>

Examples of the developer used in the organic solvent development process include developers containing one or more organic solvents such as polar solvents, e.g., ketone solvents, ester solvents, alcohol solvents, nitrile solvents, amide solvents, and ether solvents, and hydrocarbon solvents.

Specific examples of the organic solvent include:
a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
an alcohol solvent, such as methanol, ethanol, isopropyl alcohol (IPA), diacetone alcohol (DAA) 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
a nitrile solvent, such as acetonitrile, propionitrile, or benzonitrile;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether; and
a hydrocarbon solvent, such as n-pentane, n-hexane, toluene, or xylene.
These may be used alone or in combination of two or more types thereof.

Among these, the organic solvent used in the developer is preferably a polar solvent, preferably contains an amide solvent, an alcohol solvent, or an ester solvent, more preferably contains an amide solvent or an ester solvent and an alcohol solvent.
The amide solvent is preferably at least one selected from the group consisting of N,N-dimethylformamide, N,N-diethylformamide, acetamide, and N-methylpyrrolidone.

Furthermore, the ester solvent is preferably one or more selected from the group consisting of methyl lactate, ethyl lactate (EL), methyl acetate, ethyl acetate, methyl pyruvate, ethyl pyruvate, methyl methoxypropionate, and propylene glycol monomethyl ether acetate.

The alcohol solvent is preferably at least one selected from the group consisting of ethanol, isopropyl alcohol (IPA), diacetone alcohol (DAA) 3-methoxybutanol, 3-methyl-3-methoxybutanol, 1-methoxy-2-propanol, 4-methyl-2-pentanol, benzyl alcohol, and 4-methylbenzyl alcohol.

In a case where the developer contains both an amide solvent or an ester solvent and an alcohol solvent, the blend ratio (weight ratio) of the amide solvent or the ester solvent to the alcohol solvent preferably ranges from 5:95 to 95:5, more preferably 10:90 to 90:10.

The development with the developer may be followed by a step of washing with a rinse liquid. The rinse liquid is not particularly limited and may be a known and commonly used rinse liquid. As the rinse liquid, among water or the organic solvent(s) in the developer, a solvent that is less likely to dissolve the resist pattern can be appropriately selected and used.

The rinse liquid is, for example, but not limited to, at least one organic solvent selected from the group consisting of a hydrocarbon solvent, a ketone solvent, an ester solvent, an alcohol solvent, an amide solvent, and an ether solvent. Among these, the rinse liquid is preferably at least one organic solvent selected from the group consisting of a hydrocarbon solvent, a ketone solvent, an ester solvent, an alcohol solvent, and an amide solvent, more preferably at least one selected from the group consisting of an alcohol solvent and an ester solvent, still more preferably at least one alcohol solvent.

The alcohol solvent used in the rinse liquid is preferably a monohydric alcohol with 2 to 8 carbon atoms, and the monohydric alcohol may be linear, branched, or cyclic. Specific examples of the monohydric alcohol include ethanol, isopropyl alcohol (IPA), butanol, 1-hexanol, 1-heptanol, 1-octanol, 2-hexanol, 2-heptanol, 2-octanol, 3-hexanol, 3-heptanol, 3-octanol, 4-octanol, and benzyl alcohol.

These organic solvents may be used alone or in combination of two or more types thereof.

### <Development Method Using Developer and Washing Method Using Rinse Liquid>

The method for developing the exposed resist film using the developer is not particularly limited, and a known and commonly used method can be used. Examples of the method for developing using the developer include a method of immersing a substrate having the exposed resist film in the developer for a certain period of time (dip method), a method of spraying the developer onto the surface of the exposed resist film (spray method), and a method of discharging the developer from a discharge nozzle at a constant rate toward the surface of the exposed resist film on a substrate rotating at a constant speed (dynamic dispense method), or the like.

The method for washing the resist pattern with the rinse liquid is not particularly limited and can be a known and commonly used method. The method of washing using the rinse liquid is, for example, a method of immersing the resist pattern in the rinse liquid for a certain period (dip method), a method of spraying the rinse liquid onto the surface of the resist pattern (spray method), and a method of discharging the rinse liquid from a discharge nozzle at a constant speed toward the surface of the resist pattern rotating at a constant speed (dynamic dispense method), or the like.

### [3. Patterned Structure]

A patterned structure according to the present embodiment is produced by forming a pattern of the resist material on a substrate by the pattern formation method.

The average thickness of part or all of the patterned structure according to the present embodiment is not particularly limited and can be appropriately set depending on the intended use or the like. The patterned structure preferably has a portion having an average thickness of 1 to 100 nm, more preferably has a portion having an average thickness of 5 to 75 nm, and still more preferably has a portion having an average thickness of 10 to 60 nm.

The pitch of part or all of the patterned structure according to the present embodiment is not particularly limited and can be appropriately determined depending on the intended use or the like. The patterned structure preferably has a portion with a pitch of 100 nm or less, more preferably has a portion with a pitch of 50 nm or less, and still more preferably has a portion with a pitch of 20 nm or less.

The resist material according to the present embodiment can be patterned by the pattern formation method to form a portion with a pitch of 50 nm, a portion with a pitch of 20 nm, and a portion with a pitch of 15 nm in part or all of the patterned structure.

### [4. Resist Material for Electron Beam or EUV]

The resist material according to the present embodiment contains a heteropolyacid salt having a modified lacunary site or a mixture thereof, wherein a sulfonium cation, a sulfonium dication, or an io donium cation, each having one or more polar groups each having an acid-dissociable group, is used in the cation moiety of the heteropolyacid salt having a modified lacunary site or the mixture thereof. Thu s, the heteropolyacid salt having a modified lacunary site or the mixture thereof can exhibit both effects of the function of a photoacid generator and the function of changing the solubility in a developer by th e action of an acid. Thus, the resist material according to the present embodiment has high sensitivity t o an electron beam or EUV source and can be suitably used as a resist material corresponding to the e xposure source.

### EXAMPLES

The present invention will be more specifically described below with reference to examples, but the present invention is not limited to these examples.

### [1. Synthesis of Heteropolyacid Salt Having Modified Lacunary Site (Polyacid Salt)]

Polyacid salts (A-1) to (A-7) were synthesized by the following methods.

### <Production Example: Potassium Undecatungstosilicate (α-K₈[SiW₁₁O₃₉])>

380 g of 1 M acetic acid was added to 63 g of silicotungstic acid hydrate (manufactured by Nippon Inorganic Colour & Chemical Co., Ltd.: H₄[SiW₁₂O₄₀]·xH₂O), and the reaction liquid was heated to 45°C. The pH was adjusted to 6.0 by addition of potassium hydrogen carbonate (52 g). The reaction liquid was then cooled to room temperature and was suction-filtered to prepare 56 g of a crude product. 216 g of pure water was added to the crude product, followed by heating to 73°C to redissolve the crude product. The solution was cooled at 4°C for 16 hours to recrystallize, and the resulting crystals were suction-filtered and dried under vacuum to yield 34 g of the target compound.
²⁹Si-NMR (119.22 MHz, D₂O) : δ(ppm)= -84.6(s, 1Si).
¹⁸³W-NMR (20.84 MHz, D₂O) : δ(ppm)= -101.85(s, 2W), -116.26(s, 2W), -119.29(s, 1W), -125.62(s, 2W), - 140.85(s, 2W), -174.53(s, 2W).

### <Synthesis Example 1: tetrakis((4-(2-((1-ethylcyclopentyl)oxy)-2-oxoethoxy)-3,5-dimethylphenyl)diphenylsulf onium)(1,3-diphenyldisiloxane-1,1,3,3-tetrayl)undecatungstosilicate (polyacid salt (A-1))>

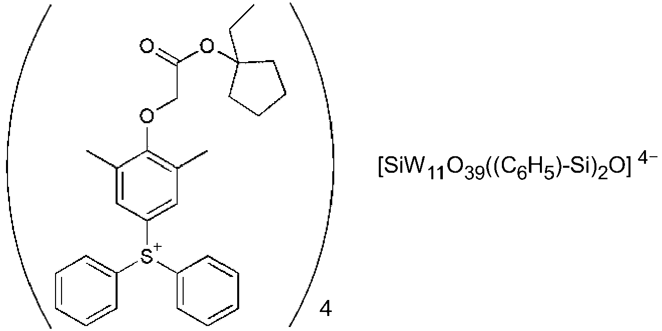

2.0 mL (10.9 mmol) of phenyltrimethoxysilane (PhSi(OCH₃)₃) was added to a mixed solvent o f 402 g of acetonitrile and 184 g of pure water, and 10.9 g (3.6 mmol) of the synthesized mono-lacuna ry Keggin-type potassium undecatungstosilicate (α-K₈[SiW₁₁O₃₉]) was added thereto. The pH was adjuste d to 1.8 using 1 M hydrochloric acid. After stirring for 2 hours, the unreacted powder was filtered off by suction filtration, and the filtrate was concentrated to approximately 200 g using a rotary evaporator. A solution of 9.9 g (18.2 mmol) of (4-(2-((1-ethylcyclopentyl)oxy)-2-oxoethoxy)-3,5-dimethylphenyl)diphe nylsulfonium bromide dissolved in 40 g of methanol was added to the concentrate to precipitate a powd er. The precipitated powder was filtered off by suction filtration and was washed three times each with 180 mL of pure water, 180 mL of methanol, and 180 mL of methyl-t-butyl ether. The powder was the n dispersed and washed with 160 g of methanol for 3 hours, was filtered off again by suction filtration, and was washed with 160 g of methanol three times. Furthermore, the powder was sufficiently dried un der vacuum to yield 15.1 g of the target compound, a polyacid salt (A-1), as a white powder.
¹H-NMR (400 MHz, DMSO-d6) : δ(ppm)=0.77-0.81(t, 12H), 1.48-1.75(m, 24H), 1.90-1.93(m, 16H), 2.29(m, 24H), 4.55(s, 8H), 7.38-7.45(m, 6H), 7.59(s, 8H), 7.74-7.82(m, 44H).
²⁹Si-NMR (119.22 MHz, DMSO-d6) : δ(ppm)=-65.54(s, 2Si), -84.97(s, 1Si).
ESI-MS: POSITIVE m/z 461.2([C₂₉H₃₃O₃S]⁺)
   NEGATIVE m/z 725.1(median)([C₁₂H₁₀O₄₀Si₃W₁₁]⁴⁻)

### <Synthesis Example 2: tetrakis((4-(2-((1-ethylcyclopentyl)oxy)-2-oxoethoxy)-3,5-dimethylphenyl)diphenylsulf onium)(1,3-di(2-carboxyethyl)disiloxane-1,1,3,3-tetrayl)undecatungstosilicate (polyacid salt (A-2))>

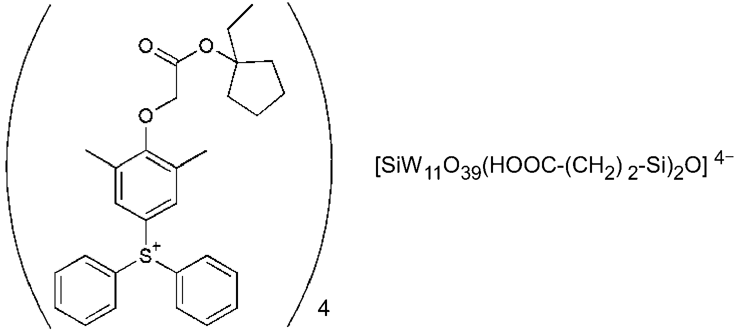

A polyacid salt (A-2) was produced as a target compound in the same manner as in Synthesis Example 1 except that 2-carboxyethyltrihydroxysilane was used as a raw material compound instead of phenyltrimethoxysilane (PhSi(OCH₃)₃).
¹H-NMR (400 MHz, DMSO-d6) : δ(ppm)=0.77-0.81(m, 16H), 1.48-1.75(m, 24H), 1.90-1.93(m, 16H), 2.29-2.37(m, 28H), 4.55(s, 8H), 7.59(s, 8H), 7.76-7.82(m, 40H), 11.97(br, 2H).
²⁹Si-NMR (119.22 MHz, DMSO-d6) : δ(ppm)=-53.31(s, 2Si), -85.07(s, 1Si).
ESI-MS: POSITIVE m/z 461.2([C₂₉H₃₃O₃S]⁺)
   NEGATIVE m/z 723.1(median)([C₆H₁₀O₄₄Si₃W₁₁]⁴⁻)

### <Synthesis Example 3: tetrakis((4-(2-((1-ethylcyclopentyl)oxy)-2-oxoethoxy)-3,5-dimethylphenyl)diphenylsulf onium)(1,3-di(3,3,3-trifluoropropyl)disiloxane-1,1,3,3-tetrayl)undecatungstosilicate (polyacid salt (A-3))>

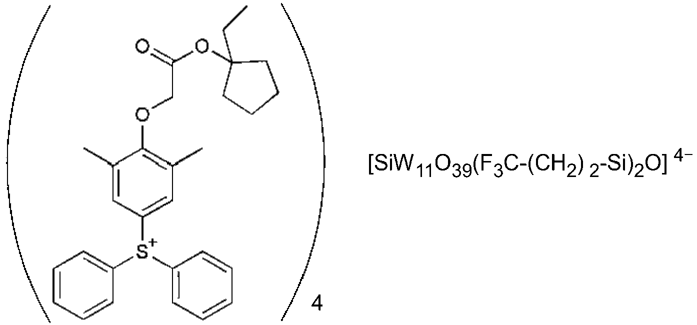

A polyacid salt (A-3) was produced as a target compound in the same manner as in Synthesis Example 1 except that 3,3,3-trifluoropropyltrimethoxysilane was used as a raw material compound instea d of phenyltrimethoxysilane (PhSi(OCH₃)₃).
¹H-NMR (400 MHz, DMSO-d6) : δ(ppm)=0.75-0.81(m, 16H), 1.48-1.75(m, 24H), 1.90-1.93(m, 16H), 2.20-2.41(m, 28H), 4.55(s, 8H), 7.59(s, 8H), 7.76-7.82(m, 40H).
²⁹Si-NMR (119.22 MHz, DMSO-d6) : δ(ppm)=-54.43(s, 2Si), -85.03(s, 1Si).
ESI-MS: POSITIVE m/z 461.2([C₂₉H₃₃O₃S]⁺)
   NEGATIVE m/z 735.1(median)([C₆H₈F₆O₄₀Si₃W₁₁]⁴⁻)

### <Synthesis Example 4: tetrakis((4-(2-((1-ethylcyclopentyl)oxy)-2-oxoethoxy)-3,5-dimethylphenyl)diphenylsulf onium)(1,3-di(4-hydroxyphenyl)disiloxane-1,1,3,3-tetrayl)undecatungstosilicate (polyacid salt (A-4))>

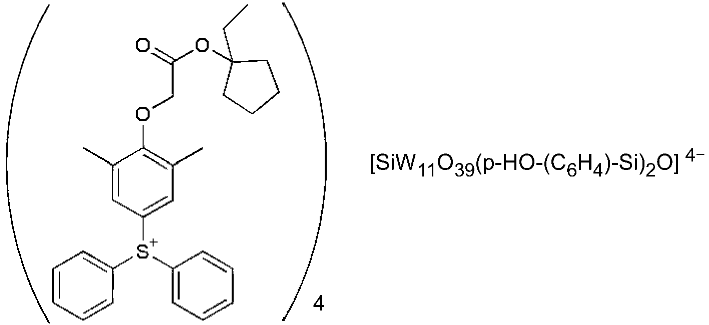

A polyacid salt (A-4) was produced as a target compound in the same manner as in Synthesis Example 1 except that 4-hydroxyphenyltrimethoxysilane was used as a raw material compound instead o f phenyltrimethoxysilane (PhSi(OCH₃)₃).
¹H-NMR (400 MHz, DMSO-d6) : δ(ppm)=0.77-0.81(t, 12H), 1.48-1.75(m, 24H), 1.90-1.93(m, 16H), 2.29(m, 24H), 4.55(s, 8H), 6.76(d, 4H), 7.54(d, 4H), 7.59(s, 8H), 7.76-7.82(m, 40H), 9.56(s, 2H).
²⁹Si-NMR (119.22 MHz, DMSO-d6) : δ(ppm)=-64.28(s, 2Si), -85.00(s, 1Si).
ESI-MS: POSITIVE m/z 461.2([C₂₉H₃₃O₃S]⁺)
   NEGATIVE m/z 733.1(median)([C₁₂H₁₀O₄₂Si₃W₁₁]⁴⁻)

### <Synthesis Example 5: tetrakis((4-(2-((1-ethylcyclopentyl)oxy)-2-oxoethoxy)-3,5-dimethylphenyl)diphenylsulf onium)(1,3-dimethyldisiloxane-1,1,3,3-tetrayl)undecatungstosilicate (polyacid salt (A-5))>

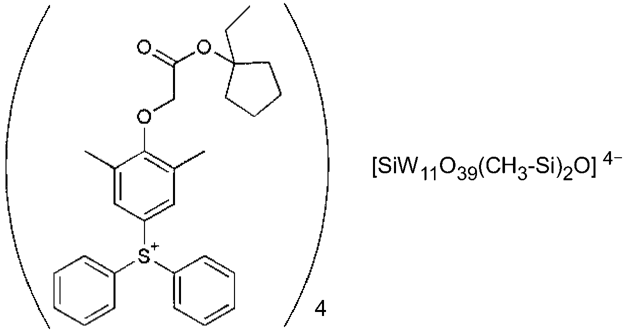

A polyacid salt (A-5) was produced as a target compound in the same manner as in Synthesis Example 1 except that methyltrimethoxysilane was used as a raw material compound instead of phenyltr imethoxysilane (PhSi(OCH₃)₃).
¹H-NMR (400 MHz, DMSO-d6) : δ(ppm)=0.04(s, 6H), 0.77-0.81(t, 12H), 1.48-1.75(m, 24H), 1.90-1.93(m, 16H), 2.29(m, 24H), 4.55(s, 8H), 7.59(s, 8H), 7.76-7.82(m, 40H).
²⁹Si-NMR (119.22 MHz, DMSO-d6) : δ(ppm)=-51.15(s, 2Si), -85.08(s, 1Si).
ESI-MS: POSITIVE m/z 461.2([C₂₉H₃₃O₃S]⁺)
   NEGATIVE m/z 694.1(median)([C₂H₆O₄₀Si₃W₁₁]⁴⁻)

### <Synthesis Example 6: tetrakis((4-(2-((2-methyl-2-adamantyl)oxy)-2-oxoethoxy)-3,5-dimethylphenyl)diphenyls ulfonium)(1,3-diphenyldisiloxane-1,1,3,3-tetrayl)undecatungstosilicate (polyacid salt (A-6))>

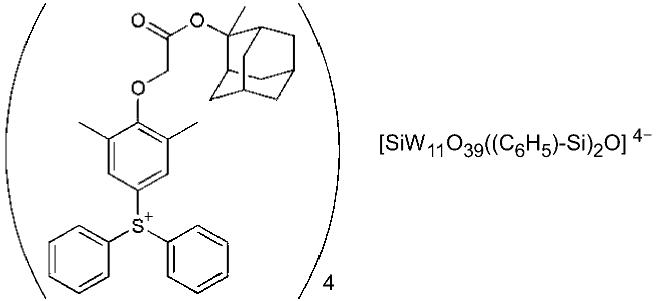

A polyacid salt (A-6) was produced as a target compound in the same manner as in Synthesis Example 1 except that (4-(2-((2-methyl-2-adamantyl)oxy)-2-oxoethoxy)-3,5-dimethylphenyl)diphenylsulfoniu m chloride was used as a raw material compound instead of (4-(2-((1-ethylcyclopentyl)oxy)-2-oxoethoxy)-3,5-dimethylphenyl)diphenylsulfonium bromide.
¹H-NMR (400 MHz, DMSO-d6) : δ(ppm)=1.49-1.97(m, 68H), 2.31(s, 24H), 4.62(s, 8H), 7.38-7.45(m, 6H), 7.61(s, 8H), 7.74-7.86(m, 44H).
²⁹Si-NMR (119.22 MHz, DMSO-d6) : δ(ppm)=-65.42(s, 2Si), -85.29(s, 1Si).
ESI-MS: POSITIVE m/z 513.2([C₃₃H₃₇O₃S]⁺)
   NEGATIVE m/z 725.1(median)([C₁₂H₁₀O₄₀Si₃W₁₁]⁴⁻)

### <Synthesis Example 7: tetrakis(triphenylsulfonium)silicotungstate (polyacid salt (A-7))>

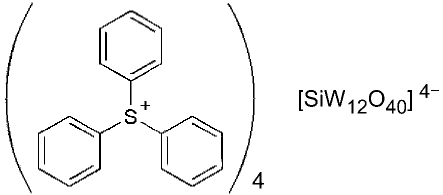

25.6 g of triphenylsulfonium chloride was dissolved in 50 g of cyclohexanone, 41.06 g of silicotungstic acid (H₄[SiW₁₂O₄₀]·26H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a polyacid salt (A-7) as a target compound.
¹H-NMR (400MHz,DMSO-D6):δ(ppm)=7.74-7.90(m,60H).
¹⁸³W-NMR (20.84MHz, DMSO-D6): δ (ppm)=-92.7(s, 12W).
ESI-MS: NEGATIVE m/z 718.5(median) ([SiW₁₂O₄₀]⁴⁻)

### [2. Preparation of Test Resist Material]

Test resist materials (R-1) to (R-11) were prepared by blending the synthesized polyacid salts (A-1) to (A-7), an acid diffusion control agent, and an organic solvent as test resist materials so as to h ave the contents (unit: parts by mass) shown in Table 1 below.

Acid diffusion control agents (B-1) to (B-3) described below were used as the (B) acid diffusion control agents described in Table 1.
- Acid diffusion control agent (B-1): an acid diffusion control agent that is a salt of a triphenylsulfonium cation represented by the following formula (B-1) and a salicylate anion 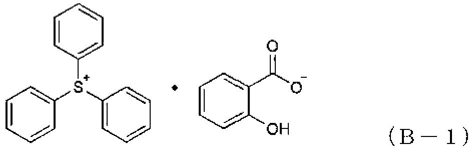
- Acid diffusion control agent (B-2): an acid diffusion control agent that is a salt of a (4-(2-((1-ethylcyclopentyl)oxy)-2-oxoethoxy)-3,5-dimethylphenyl)diphenylsulfonium cation represented by the following formula (B-2) and a salicylic acid anion 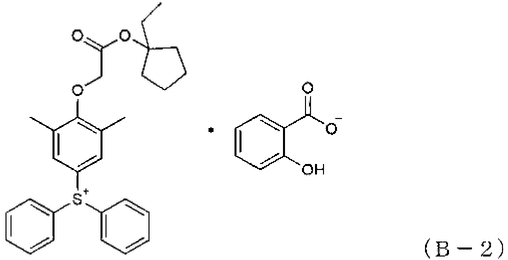
- Acid diffusion control agent (B-3): an acid diffusion control agent that is a salt of a triphenylsulfonium cation represented by the following formula (B-3) and a heptafluorobutyric acid anion

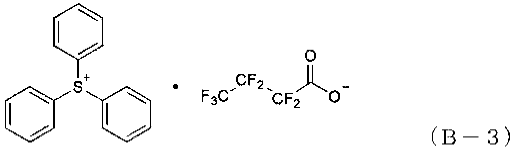

**[Table 1]**

| Components | | R-1 | R-2 | R-3 | R-4 | R-5 | R-6 | R-7 | R-8 | R-9 | R-10 | R-11 |
|---|---|---|---|---|---|---|---|---|---|---|---|---|
| (A) | Polyacid salt (A-1) | 2 | 2 | | | | | | 2 | 2 | | |
| | Polyacid salt (A-2) | | | 2 | | | | | | | | |
| | Polyacid salt (A-3) | | | | 2 | | | | | | | |
| | Polyacid salt (A-4) | | | | | 2 | | | | | | |
| | Polyacid salt (A-5) | | | | | | 2 | | | | | |
| | Polyacid salt (A-6) | | | | | | | 2 | | | | |
| | Polyacid salt (A-7) | | | | | | | | | | 2 | 2 |
| (B) | Acid diffusion control agent (B-1) | | 0.12 | 0.12 | 0.12 | 0.12 | 0.12 | 0.12 | | | | 0.12 |
| | Acid diffusion control agent (B-2) | | | | | | | | 0.12 | | | |
| | Acid diffusion control agent (B-3) | | | | | | | | | 0.12 | | |
| | γ-butyrolactone | 10 | 10 | 10 | 10 | 10 | 10 | 10 | 10 | 10 | 15 | 15 |
| Organic solvent | Cyclopentanone | 90 | 90 | 90 | 90 | 90 | 90 | 90 | 90 | 90 | | |
| | Diacetone alcohol | | | | | | | | | | 85 | 85 |

### [3. Preparation of LS Pattern]

Each of the resist materials R-1 to R-11 was applied using a spinner to an 8-inch silicon substrate subjected to a hexamethyldisilazane (HMDS) treatment, was subjected to a post-apply bake (PAB) treatment on a hot plate at a temperature of 120°C for 60 seconds, and was dried to form a resist film with a thickness of 50 nm. The thickness of the formed film was measured with a thickness measuring apparatus ("M-2000D" manufactured by J. A. Woollam).

Lithography (exposure) was performed on the resist film using an electron-beam lithography system F7000S-VD2 (manufactured by Advantest Corporation) at an accelerating voltage of 50 kV such that the target size was a 1:1 line-and-space pattern (hereinafter also referred to as an "LS pattern") with a line width of 50 nm. Post-exposure bake (PEB) treatment was then performed at 90°C for 60 seconds.

Development was then performed at 23°C for 60 seconds using a developer (NMD-W (manufactured by Tokyo Ohka Kogyo Co., Ltd.)), and rinsing was performed for 15 seconds using pure water.

As a result, 1:1 LS patterns with a line width of 50 nm were formed, and LS patterns (LS-1) to (LS-11) corresponding to the test resist materials (R-1) to (R-11) were formed. All of the LS patterns (LS-1) to (LS-11) are positive patterns.

### [4. Evaluation of Shape of LS Pattern]

The shapes of the LS patterns (LS-1) to (LS-11) were observed with a critical dimension scanning electron microscope (SEM) (accelerating voltage: 10 kV, trade name: SU-5000, manufactured by Hitachi High-Tech Corporation) and were evaluated in accordance with the following criteria. Table 2 shows the results.
A: Almost no tailing is observed in the LS pattern of the SEM image, and the resolution is good.
B: Tailing is slightly observed in part of the LS pattern of the SEM image.
C: The LS pattern is not formed (not resolved) in the entire SEM image.

**[Table 2]**

| | LS-1 | LS-2 | LS-3 | LS-4 | LS-5 | LS-6 | LS-7 | LS-8 | LS-9 | LS-10 | LS-11 |
|---|---|---|---|---|---|---|---|---|---|---|---|
| Pattern resolution | B | A | A | A | A | A | A | A | A | C | C |

The results in Table 2 show that the resist materials (R-1) to (R-9) containing the polyacid sa lts (A-1) to (A-6), each having a polar group having an acid-dissociable group in the cation moiety, can be used to form a LS pattern with a line width of 50 nm with almost no tailing with high resolution (( LS-1) to (LS-9)).

Furthermore, a comparison of the pattern resolutions of (LS-1) and (LS-2) indicates that a LS pattern with higher resolution can be formed by using the resist material (R-2), which further contains th e acid diffusion control agent (B-1), as compared with the resist material (R-1) containing the polyacid s alt (A-1), which has a polar group having an acid-dissociable group in the cation moiety.

## Claims

1. A resist material comprising (A) a heteropolyacid salt having a modified lacunary site represen ted by the general formula (I) or a mixture thereof.
(A^{m+})ₐ(Bⁿ⁺)_{b}(C^{(am+bn)-}) (I)
[in the formula (I),
A^{m+} each independently denotes H⁺, a metal ion, an ammonium cation, an ammonium dication , a phosphonium cation, or a phosphonium dication;
Bⁿ⁺ each independently denotes a sulfonium cation, a sulfonium dication, or an iodonium catio n, each having one or more polar groups each having an acid-dissociable group;
C^{(am+bn)-} denotes a heteropolyacid anion having a lacunary site in which the lacunary site is m odified; and
m denotes an integer in the range of 1 to 5, n denotes an integer of 1 or 2, a denotes a real number, and b denotes a real number greater than 0]

2. The resist material according to claim 1, wherein the sulfonium cation, sulfonium dication, or iodonium dication having one or more polar groups each having an acid-dissociable group is an organic sulfonium cation, an organic sulfonium dication, or an organic iodonium cation having one or more polar groups each having an acid-dissociable group.

3. The resist material according to claim 1, wherein the acid-dissociable group is a tertiary-carbo n-type acid-dissociable group, an allyl- or benzyl-type acid-dissociable group, an acetal-type acid-dissociab le group, or an aminocarbonyl-type acid-dissociable group.

4. The resist material according to claim 1, wherein the heteropolyacid anion has a polyatom of Mo, W, V, Nb, or Ta and a heteroatom of P, Si, B, S, or Ge.

5. The resist material according to claim 1, wherein the heteropolyacid anion having the lacunary site is a lacunary Keggin-type heteropolyacid anion or a lacunary Dawson-type heteropolyacid anion.

6. The resist material according to claim 1, wherein the modification is performed by bonding a group having one or more heteroatoms of P, Si, Ge, or Sn, to which one or more organic groups are b onded, to the heteropolyacid anion having the lacunary site via a part or all of the heteroatoms.

7. The resist material according to claim 1, further comprising (B) an acid diffusion control agen t.

8. The resist material according to claim 7, wherein the (B) acid diffusion control agent is (B1) a photodegradable base.

9. The resist material according to claim 1, further comprising an organic solvent.

10. The resist material according to any one of claims 1 to 9, which is a resist material for an el ectron beam or EUV.

11. A pattern formation method comprising:
a step of forming a resist film using the resist material according to any one of claims 1 to 9;
a step of exposing the resist film; and
a step of developing the exposed resist film using a developer.

12. The pattern formation method according to claim 11, wherein the step of exposing the resist f ilm includes a step of exposing the resist film to an electron beam with a dose of 2 mC/cm² or less or extreme ultraviolet of 200 mJ/cm² or less.

13. A patterned structure formed by patterning the resist material according to any one of claims 1 to 9.
